(19) Europäisches Patentamt
European Patent Office
Office européen des brevets

(11) EP 2 632 232 A1

(12) EUROPEAN PATENT APPLICATION
published in accordance with Art. 153(4) EPC

(43) Date of publication:
28.08.2013 Bulletin 2013/35

(21) Application number: 11834062.9

(22) Date of filing: 20.10.2011

(51) Int Cl.:
*H05B 33/12* (2006.01) *H01L 51/50* (2006.01)

(86) International application number:
PCT/JP2011/005879

(87) International publication number:
WO 2012/053216 (26.04.2012 Gazette 2012/17)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR

(30) Priority: 20.10.2010 JP 2010235956

(71) Applicant: Idemitsu Kosan Co., Ltd.
Chiyoda-ku
Tokyo 100-8321 (JP)

(72) Inventors:
- ARAKANE, Takashi
Sodegaura-shi
Chiba 299-0293 (JP)
- NISHIMURA, Kazuki
Sodegaura-shi
Chiba 299-0293 (JP)
- FUKUOKA, Kenichi
Sodegaura-shi
Chiba 299-0293 (JP)
- KUMA, Hitoshi
Sodegaura-shi
Chiba 299-0293 (JP)
- JINDE, Yukitoshi
Sodegaura-shi
Chiba 299-0293 (JP)

(74) Representative: Gille Hrabal
Brucknerstrasse 20
40593 Düsseldorf (DE)

# (54) TANDEM ORGANIC ELECTROLUMINESCENT ELEMENT

(57) A tandem organic electroluminescence device including a first emitting unit (3), an intermediate unit (4) and a second emitting unit (5) being stacked between opposing electrodes(2) and (6) the first emitting unit (3) including a blue fluorescent dopant and a red fluorescent dopant and the second emitting unit (5) including a red phosphorescent dopant and a green phosphorescent dopant

FIG.1

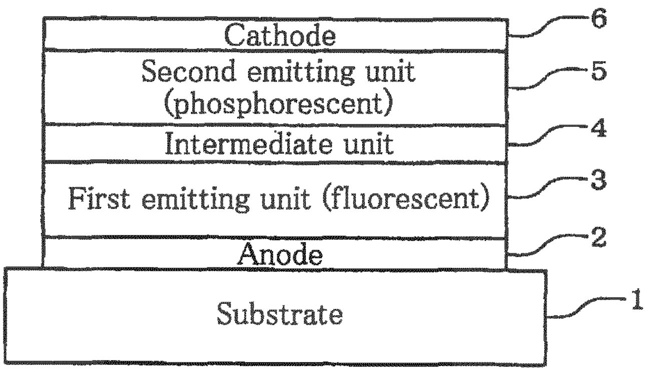


EP 2 632 232 A1

**Description**

Technical Field

The invention relates to a tandem organic electroluminescence device, in particular, to a warm color (having a low color temperature) white organic electroluminescence device.

Background Art

In recent years, development of a white color organic electroluminescence device (organic EL device) has been actively conducted due to its application as a mono-color display apparatus, illumination such as backlight, a full-color display device using a color filter or the like. In particular, when a white organic EL device is used in illumination, a white organic EL device is required to have a high luminous efficiency which is equal to or higher than the luminous efficiency of a fluorescent organic EL device. Many methods for obtaining white emission by an organic EL device are known. Of these methods, only a few methods can obtain white emission by using one emitting material. Normally, two or three types of emitting materials are caused to emit light simultaneously in one organic EL device.

Most of conventional white color organic EL devices for use in illumination purposes are non-stack all-fluorescence devices (non-tandem devices which only emit fluorescent color)(Patent Document 1). However, since all emission color is fluorescent color, these devices have low luminous efficiency. FIG 7 shows the relationship between the color temperature and the efficiency of a non-static all fluorescence device.

In a non-stack device, a blue emitting layer, a green emitting layer and a red emitting layer are provided between a pair of electrodes. Therefore, in principal, it is possible to cause to emit an arbitral color emphatically by improving the device configuration. However, when emitting layers are stacked, energy excited by the recombination of electrons and holes tends to be diffused to adjacent emitting layers. In particular, since diffusion of energy from a blue emitting layer having a high energy level is significant, adjustment of the color temperature of a white emitting device is not easy.

On the other hand, a white emitting tandem device is known (Patent Document 2). In particular, in a tandem device, as for red and green colors, a technology has already been developed for improving the luminous efficiency by using a phosphorescent material which has already been put into practical use, thereby to improve the luminance of white color (Patent Document 3). In Example 3 of Patent Document 3, two phosphorescent layers and a fluorescent layer are stacked with an intermediate layer being present therebetween, i.e. a structure represented by phosphorescent red emitting layer and phosphorescent green emitting layer/intermediate layer/fluorescent blue emitting layer. FIG 7 shows the relationship between the color temperature and the efficiency of such tandem device. As shown in FIG 7, in a region where the color temperature is high, a high luminous efficiency can be obtained. However, in a region where the color temperature is low, luminous efficiency is lowered in order to suppress blue fluorescence.

Related Art Documents

Patent Document 1: WO2007/138906
Patent Document 2: WO2007/005200
Patent Document 3: JP-A-2005-267990

Summary of the Invention

An object of the invention is to provide a device which has a high luminous efficiency in a region where the color temperature is low and has a long life.

According to the invention, the following organic EL device is provided.

1. A tandem organic electroluminescence device comprising a first emitting unit, an intermediate unit and a second emitting unit being stacked between opposing electrodes,
the first emitting unit comprising a fluorescent dopant having an emission wavelength of 400 to 490 nm and a fluorescent dopant having an emission wavelength of 560 to 700 nm; and
the second emitting unit comprising a phosphorescent dopant having an emission wavelength of 560 to 700 nm and a phosphorescent dopant having an emission wavelength of 490 to 560 nm.

2. The organic electroluminescence device according to 1, wherein the first emitting unit comprises a blue fluorescent dopant and a yellow fluorescent dopant and the second emitting unit comprises a red phosphorescent dopant and a green phosphorescent dopant.

3. The organic electroluminescence device according to 1, wherein
the first emitting unit comprises a first emitting layer and a second emitting layer;
the first emitting layer comprises the yellow fluorescent dopant;
the second emitting layer comprises the blue fluorescent dopant;
the second emitting unit comprises a third emitting layer and a fourth emitting layer;
the third emitting layer comprises the red phosphorescent dopant; and
the fourth emitting layer comprises the green phosphorescent dopant.
4. A tandem organic electroluminescence device comprising a first emitting unit, an intermediate unit and a second emitting unit being stacked between opposing electrodes,
the first emitting unit comprising a blue fluorescent dopant and a red fluorescent dopant; and the second emitting unit comprising a red phosphorescent dopant and a green phosphorescent dopant.
5. The organic electroluminescence device according to 4, wherein
the first emitting unit comprises a first emitting layer and a second emitting layer;
the first emitting layer comprises the red fluorescent dopant;
the second emitting layer comprises the blue fluorescent dopant;
the second emitting unit comprises a third emitting layer and a fourth emitting layer;
the third emitting layer comprises the red phosphorescent dopant; and
the fourth emitting layer comprises the green phosphorescent dopant.
6. The organic electroluminescence device according to 5, wherein the first emitting unit comprises a blocking layer which is adjacentto the second emitting layer.
7. The organic electroluminescence device according to 5 or 6, wherein the second emitting layer comprises a host compound and the triplet energy of the host compound is smaller than the triplet energy of the compound forming the blocking layer.
8. The organic electroluminescence device according to 7, wherein the triplet energy of the blue fluorescent dopant is smaller than the triplet energy of the compound forming the blocking layer.
9. The organic electroluminescence device according to any of 5 to 8, wherein the first emitting unit comprises a space layer between the first emitting layer and the second emitting layer.

According to the invention, it is possible to provide a device which has a high luminous efficiency in a region where the color temperature is low and has a long life.

Brief Description of the Drawings

FIG. 1 is a view showing one embodiment of the organic EL device of the invention;
FIG. 2 is a view showing a first emitting unit of the organic EL device shown in FIG 1;
FIG. 3 is a view showing a second emitting unit of the organic EL device shown in FIG. 1;
FIG. 4 is a view showing another example of the first emitting unit;
FIG. 5A is a view showing the relationship of the energy gap of the blocking layer and that of the emitting layer which is adjacent to the blocking layer;
FIG. 5B is a view showing the action based on the relationship of the energy gap of the blocking layer and that of the emitting layer which is adjacent to the blocking layer;
FIG. 6 is a view showing another example of the first emitting unit; and
FIG. 7 is a view showing the relationship between the color temperature and the efficiency of the conventional device.

Mode for Carrying out the Invention

The organic EL device of the invention is a tandem organic electroluminescence device comprising a first emitting layer, an intermediate unit and a second emitting unit being stacked between opposing electrodes, wherein the first emitting unit comprises a blue fluorescent dopant and a red fluorescent dopant, and the second emitting unit comprises a red phosphorescent dopant and a green phosphorescent dopant.
The opposing electrodes are an anode and a cathode, and the first emitting unit may be on the anode side or the cathode side.
The first emitting unit may be a stacked fluorescent emitting layer of a blue emitting layer and a red emitting layer or may be a fluorescent layer of a mixture of a blue emitting layer and a red emitting layer. The second emitting unit may be a stacked phosphorescent emitting layer of a red emitting layer and a green emitting layer or may be a phosphorescent layer of a mixture of a red emitting layer and a green emitting layer.

The organic EL device of the invention may comprises three or more emitting units.
In another embodiment, the organic EL device is a tandem organic EL device comprising a first emitting unit, an intermediate unit and a second emitting unit being stacked between opposing electrodes,
the first emitting unit comprising a fluorescent dopant having an emission wavelength of 400 to 490 nm and a fluorescent dopant having an emission wavelength of 560 to 700 nm; and
the second emitting unit comprising a phosphorescent dopant having an emission wavelength of 560 to 700 nm and a phosphorescent dopant having an emission wavelength of 490 to 560 nm.
The first emitting unit may comprise the blue fluorescent dopant and the yellow fluorescent dopant; and the second emitting unit may comprise the red phosphorescent dopant and the green phosphorescent dopant.
Further, the first emitting unit may comprise a first emitting layer and a second emitting layer, and the first emitting layer may comprise the yellow fluorescent dopant, the second emitting layer may comprise the blue fluorescent dopant, the second emitting unit may comprise a third emitting layer and a fourth emitting layer, the third emitting layer may comprise the red phosphorescent dopant, and the fourth emitting layer may comprise the green phosphorescent dopant.
Here, the emission wavelength of the emission color of the emitting unit and dopant contained in the emitting unit mean the maximum wavelength ("main peak wavelength") of the peak wavelengths of the emission spectrum of the dopant in the solution state.
The main peak wavelength means the peak wavelength of an emission spectrum at which the emission intensity is the maximum in the emission spectra measured in a toluene solution having a concentration of $10^{-5}$ mol/l or more and $10^{-6}$ mol/l or less.
The peak wavelength of the emission spectrum in the solution measured by this method is about 10 nm shorter than the peak wavelength of emission from the emitting layer of a device prepared by using the same dopant (that is, the maximum wavelength of emission of each element mentioned later (a red fluorescent emitting layer, a blue fluorescent emitting layer, a green phosphorescent emitting layer and a red phosphorescent emitting layer). The reason therefor is that, the concentration of a dopant contained in a solution is lower than the concentration of a dopant contained in a device.

One embodiment of the organic EL device of the invention is shown in FIG. 1.
In FIG. 1, on a substrate 1, an anode 2, a first emitting unit 3, an intermediate unit 4, a second emitting unit 5 and a cathode 6 are stacked.
For example, as shown in FIG. 2, the first emitting unit 3 comprises a hole-transporting region 31, a first emitting layer (fluorescence) 32, a second emitting layer (fluorescence) 33 and an electron-transporting region 34. One of the first emitting layer 32 and the second emitting layer 33 is a blue fluorescent emitting layer and the other is a red fluorescent emitting layer. The first emitting layer 32 and the second emitting layer 33 each may be a fluorescent emitting layer (single layer) of a mixture of blue and red.
For example, as shown in FIG. 3, the second emitting unit 5 comprises a hole-transporting region 51, a third emitting layer (phosphorescence) 52, a fourth emitting layer (phosphorescence) 53 and an electron-transporting region 54. One of the third emitting layer 52 and the fourth emitting layer 53 is a green phosphorescent emitting layer, and the other is a red phosphorescent emitting layer. The third emitting layer 52 and the fourth emitting layer 53 may be a phosphorescent emitting layer (single layer) of a mixture of green and red.

As shown in FIG. 4, when the first emitting layer 32 is a red fluorescent emitting layer and the second emitting layer 33 is a blue fluorescent emitting layer, it is preferred that the first emitting unit 3 have a blocking layer 34a in contact with the blue fluorescent emitting layer 33 in an electron-transporting region 34. Due to the presence of this blocking layer 34a, triplet excitons generated in the blue fluorescent emitting layer 33 are confined within the emitting layer, and the triplet excitons collide and are fused at a high frequency to generate singlet excitons (this phenomenon is hereinafter referred to as the Triplet-Triplet Fusion = TTF phenomenon), whereby fluorescent emission can be conducted efficiently.
Specifically, when the blue fluorescent emitting layer 33 contains a host compound and a blue fluorescent dopant, by allowing the triplet energy $E^T_h$ of the host compound to be smaller than the triplet energy $E^T_b$ of the compound forming the block layer 34a, the triplet energy $E^T_h$ of the host compound is prevented from diffusing to the block layer 34a. Also, by allowing the triplet energy $E^T_d$ of the blue fluorescent emitting dopant to be smaller than the triplet energy $E^T_h$ of the compound forming the block layer 34a, the triplet energy $E^T_d$ of the dopant is prevented from diffusing to the block layer 34a.

Preferred examples are shown in FIGs. 5A and 5B. As shown in FIG. 5A, when taking the triplet energy of the host and the dopant as $E^T_h$ and $E^T_d$, respectively, a relationship $E^T_h < E^T_d$ is satisfied. By satisfying this relationship, further as shown in FIG. 5B, triplet excitons recombined and generated on the host do not move to a dopant which has a higher triplet energy. The triplet excitons recombined and generated on dopant molecules is rapidly energy-transferred to host molecules. That is, due to collision of triplet excitons on the host efficiently by a TTF phenomenon without move of triplet excitons to a dopant, singlet excitons are generated. Further, since the singlet energy $E^S_d$ of the dopant is smaller than the singlet energy $E^S_h$ of the host, singlet excitons generated by the TTF phenomenon are energy-transferred from the host to the dopant, thereby contributing to the fluorescent emission of the dopant. By allowing the relationship of the triplet energy of the block layer, the host and the dopant to that mentioned above, triplet excitons collide with each

other before the triplet excitons are thermally deactivated, whereby singlet excitons are generated efficiently, whereby luminous efficiency is improved.

When the first emitting unit 4 has a fluorescent emitting layer of a mixture of blue and red, the above-mentioned effects can be obtained by providing a blocking layer adjacent to this mixture fluorescent emitting layer in an electron transporting region.

The triplet energy can be measured by means of a commercially available apparatus F-4500 (manufactured by Hitachi Ltd.). $E^T$ can be converted by the following formula:

$$E^T(eV)=1239.85/\lambda_{edge}$$

The "$\lambda_{edge}$" means, when the phosphorescent intensity and the wavelength are taken at the vertical axis and the horizontal axis respectively to express a phosphorescent spectrum and a tangential line is drawn against the rise on the shorter wavelength side of the phosphorescent spectrum, a wavelength value at which the tangential line and the horizontal axis cross (unit: nm).

As shown in FIG 6, in the first emitting unit 3, between the first emitting layer 32 and the second emitting layer 33, a space layer 35 (charge blocking layer) may be provided. The charge blocking layer serves to block energy of the HOMO level and the LUMO level between the adjacent emitting layers to adjust charge injection to the emitting layer, whereby carrier balance of injected electrons and holes in the emitting layer can be controlled.

In a tandem device, since an intermediate electrode layer (intermediate unit) is provided between a pair of electrodes, the same amount of current is flown to the first emitting unit and the second emitting unit. In a conventional tandem device having a blue emitting unit and red/green emitting unit disclosed in Patent Document 3, the same amount of current is flown to the blue emitting unit and the red/green unit. Here, for blue color, since no phosphorescent material which is suited to practical use is available, the luminous efficiency is about 25% in terms of internal quantum efficiency. For red/green colors, if a commercially available phosphorescent material is used, about 100% of internal quantum efficiency can be obtained. However, if the red/green emitting layers are included in the single emitting unit, the amount of current which can be used in each emitting layer is decreased by half (50%).

In such a tandem configuration, since only the blue emitting layer is included in the single emitting unit, white color emission having a high color temperature can be obtained. In order to obtain a white emitting device having a low color temperature, it is required to lower the luminous efficiency of the blue emitting layer. If the luminous efficiency of the blue emitting layer is decreased, the lifetime of the device is also shortened. A white emitting device having a high color temperature is suitable for use in a display which requires a color temperature of 10000K or higher, however, a warm white color emitting device cannot be realized.

However, according to the invention, in the first emitting unit of a tandem organic EL device having the first emitting unit (fluorescence) and the second emitting unit (phosphorescence), by forming an emitting layer in such a manner that a red emitting layer is stacked on a blue emitting layer or by forming an emitting layer as a mixture layer, a warm color white emitting device is realized, and at the same time, luminous efficiency is effectively improved by using a highly efficient blue device configuration. Further, by using a highly efficient blue device configuration, improvement of the lifetime of an entire device can be achieved.

The invention is particularly effective in that the lifetime of an entire device can be improved by the above-mentioned highly efficient blue fluorescent device configuration which uses the TTF phenomenon. Therefore, in an illumination having a low color temperature (e.g. color temperature: 2500K to 4000K), a highly efficient device for illumination can be realized. In the meantime, the color temperature means a color temperature according to JIS Z 8725.

Hereinbelow, a material for each element will be explained.

(1) Red fluorescent emitting layer

The red fluorescent emitting layer is an emitting layer having a maximum wavelength of emission of preferably 570 to 700 nm, more preferably 570 to 650 nm, and red color includes yellow. It is preferred that the red fluorescent emitting layer comprise a host compound and a red fluorescent dopant and/or a yellow fluorescent dopant.

It is preferred that the energy gap of the host compound be larger than the energy gap of the red fluorescent dopant (or yellow fluorescent dopant). As the host compound, a fused aromatic ring derivative is preferable. As the fused aromatic ring derivative, an anthracene derivative, a bisanthracene derivative, a naphthacene derivative or a fluoranthene derivative are preferable.

As the red fluorescent dopant and the yellow fluorescent dopant, one having an energy gap of 1.9 to 2.3 eV is preferable. As the red fluorescent dopant, a fluoranthene derivative, an indenoperylene derivative and a boron complex can be given.

As the anthracene derivative, a compound represented by the following formula (10) is preferable.

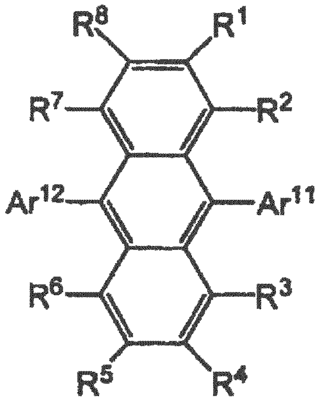

(10)

In the formula (10), $Ar^{11}$ and $Ar^{12}$ are independently a substituted or unsubstituted aryl group having 6 to 50 carbon atoms that form a ring (hereinafter referred to as the "ring carbon atoms") or a heterocyclic group having 5 to 50 atoms that form a ring (hereinafter referred to as the "ring atoms");
$R^1$ to $R^8$ are independently a group or an atom selected from a hydrogen atom, a substituted or unsubstituted aryl group having 6 to 50 ring carbon atoms, a substituted or unsubstituted heterocyclic group having 5 to 50 ring atoms, a substituted or unsubstituted alkyl group having 1 to 50 carbon atoms, a substituted or unsubstituted cycloalkyl group having 3 to 50 ring carbon atoms, a substituted or unsubstituted alkoxy group having 1 to 50 carbon atoms, a substituted or unsubstituted aralkyl group having 7 to 50 carbon atoms, a substituted or unsubstituted aryloxy group having 6 to 50 ring carbon atoms, a substituted or unsubstituted arylthio group having 6 to 50 ring carbon atoms, a substituted or unsubstituted alkoxycarbonyl group having 2 to 50 carbon atoms, a substituted or unsubstituted silyl group, a carboxyl group, a halogen atom, a cyano group, a nitro group and a hydroxyl group.
The anthracene derivative is preferably one of the following anthracene derivatives (A), (B) and (C), and a preferable anthracene derivative is selected according to the configuration or required properties of an organic EL device to which it is applied.

(Anthracene derivative (A))

This anthracene derivative is the one represented by the formula (10) in which $Ar^{11}$ and $Ar^{12}$ are independently a substituted or unsubstituted fused aryl group having 10 to 50 ring carbon atoms. This anthracene derivative can be divided into one in which $Ar^{11}$ and $Ar^{12}$ are the same substituted or unsubstituted fused aryl group or one in which $Ar^{11}$ and $Ar^{12}$ are different substituted or unsubstituted fused aryl groups.
Specifically, anthracene derivatives represented by the following formulas (2-1) to (2-3) and anthracene derivatives represented by the formula (10) in which $Ar^{11}$ and $Ar^{12}$ are different substituted or unsubstituted fused aryl groups can be given.
In the anthracene derivative represented by the following formula (2-1), $Ar^{11}$ and $Ar^{12}$ are independently a substituted or unsubstituted 9-phenanthrenyl group.

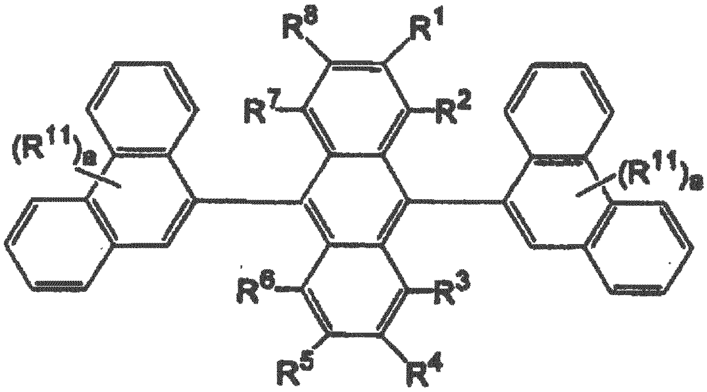

(2-1)

In the formula (2-1), $R^1$ to $R^8$ are the same as those mentioned above; $R^{11}$ is an atom or a group selected from a hydrogen atom, a substituted or unsubstituted aryl group having 6 to 50 ring carbon atoms, a substituted or unsubstituted

heterocyclic group having 5 to 50 ring atoms, a substituted or unsubstituted alkyl group having 1 to 50 carbon atoms, a substituted or unsubstituted cycloalkyl group having 3 to 50 ring carbon atoms, a substituted or unsubstituted alkoxy group having 1 to 50 carbon atoms, a substituted or unsubstituted aralkyl group having 7 to 50 carbon atoms, a substituted or unsubstituted aryloxy group having 6 to 50 ring carbon atoms, a substituted or unsubstituted arylthio group having 6 to 50 ring carbon atoms, a substituted or unsubstituted alkoxycarbonyl group having 2 to 50 carbon atoms, a substituted or unsubstituted silyl group, a carboxyl group, a halogen atom, a cyano group, a nitro group and a hydroxyl group; and a is an integer of 0 to 9, and when a is an integer of 2 or more, plural $R^{11}$s may be the same or different on the condition that the two substituted or unsubstituted phenanthrenyl groups are the same.

The anthracene derivative represented by the following formula (2-2) is the one represented by the formula (10) in which $Ar^{11}$ and $Ar^{12}$ are independently a substituted or unsubstituted 2-naphthyl group.

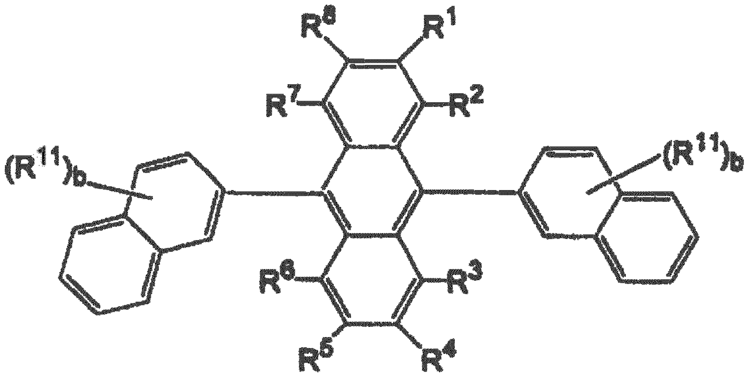

(2-2)

In the formula (2-2), $R^1$ to $R^8$ and $R^{11}$ are as defined above;
b is an integer of 1 to 7, and when b is an integer of 2 or more, plural $R^{11}$s may be the same or different on the condition that the two substituted or unsubstituted 2-naphthyl groups are the same.

The anthracene derivative represented by the following formula (2-3) is one represented by the formula (10) in which $Ar^{11}$ and $Ar^{12}$ are independently a substituted or unsubstituted 1-naphthyl group.

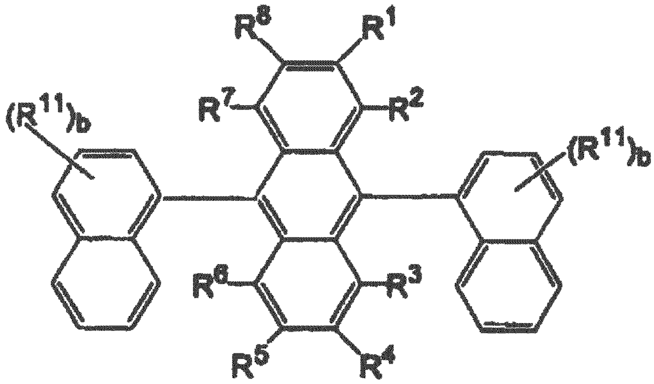

(2-3)

In the formula (2-3), $R^1$ to $R^8$, $R^{11}$ and b are as defined above. When b is an integer of 2 or more, plural $R^{11}$s may be the same or different on the condition that the two substituted or unsubstituted 1-naphthyl groups are the same.

As for the anthracene derivative represented by the formula (10) in which $Ar^{11}$ and $Ar^{12}$ are different substituted or unsubstituted fused aryl groups, it is preferred that $Ar^{11}$ and $Ar^{12}$ be any of a substituted or unsubstituted 9-phenanthrenyl group, a substituted or unsubstituted 1-naphthyl group and a substituted or unsubstituted 2-naphthyl group. Specifically, preferred are an anthracene derivative in which $Ar^{11}$ is a 1-naphthyl group and $Ar^{12}$ is a 2-naphthyl group; an anthracene derivative in which $Ar^{11}$ is a 1-naphthyl group and $Ar^{12}$ is a 9-phenanthryl group and an anthracene derivative in which $Ar^{11}$ is a 2-naphthyl group and $Ar^{12}$ is a 9-phenanthryl group.

(Anthracene derivative (B))

This anthracene derivative is one represented by the formula (10) in which one of $Ar^{11}$ and $Ar^{12}$ is a substituted or unsubstituted phenyl group and the other is a substituted or unsubstituted fused aryl group having 10 to 50 ring carbon

atoms. Specific examples of the anthracene derivative include anthracene derivatives represented by the following formulas (2-4) and (2-5).

The anthracene derivative represented by the following formula (2-4) is the one represented by the formula (10) in which $Ar^{11}$ is a substituted or unsubstituted 1-naphthyl group and $Ar^{12}$ is a substituted or unsubstituted phenyl group.

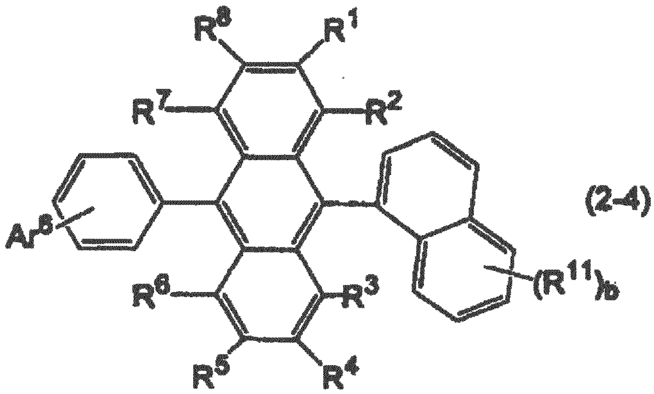

(2-4)

In the formula (2-4), $R^1$ to $R^8$, $R^{11}$ and b are as defined above, $Ar^6$ is aryl group having 6 to 50 ring carbon atoms, a substituted or unsubstituted alkyl group having 1 to 50 carbon atoms, a substituted or unsubstituted cycloalkyl group having 3 to 50 ring carbon atoms, a substituted or unsubstituted aralkyl group having 7 to 50 carbon atoms, a substituted or unsubstituted heterocyclic group having 5 to 50 ring atoms, a 9,9-dimethylfluorene-1-yl group, a 9,9-dimethylfluorene-2-yl group, a 9,9-dimethylfluorene-3-yl group, a 9,9-dimethylfluorene-4-yl group, a dibenzofuran-1-yl group, a dibenzofuran-2-yl group, a dibenzofuran-3-yl group or a dibenzofuran-4-yl group. $Ar^6$ may form a ring, together with a benzene ring to which it is bonded, such as a substituted or unsubstituted fluorenyl group or a substituted or unsubstituted dibenzofuranyl group or the like. If b is an integer of 2 or more, plural $R^{11}$s may be the same or different.

The anthracene derivative represented by the following formula (2-5) is one which is represented by the formula (10) in which $Ar^{11}$ is a substituted or unsubstituted 2-naphthyl group and $Ar^{12}$ is a substituted or unsubstituted phenyl group.

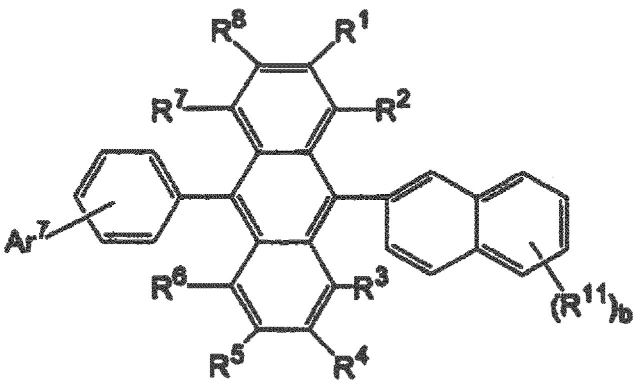

(2-5)

In the formula (2-5), $R^1$ to $R^8$, $R^{11}$ and b are as defined above.

$Ar^7$ is a substituted or unsubstituted aryl group having 6 to 50 ring carbon atoms, a substituted or unsubstituted heterocyclic group having 5 to 50 ring atoms, a substituted or unsubstituted alkyl group having 1 to 50 carbon atoms, a substituted or unsubstituted cycloalkyl group having 3 to 50 ring carbon atoms substituted or unsubstituted aralkyl group having 7 to 50 carbon atoms, a dibenzofuran-1-yl group, a dibenzofuran-2-yl group, a dibenzofuran-3-yl group or a dibenzofuran-4-yl group. $Ar^7$ may form a ring, together with a benzene ring to which it is bonded, such as a substituted or unsubstituted fluorenyl group or a substituted or unsubstituted dibenzofuranyl group. If b is an integer of 2 or more, plural $R^{11}$s may be the same or different.

(Anthracene derivative (C))

The anthracene derivative is represented by the following formula (2-6). Specifically, it is preferred that the

anthracene derivative be one represented by any of the following formulas (2-6-1), (2-6-2) and (2-6-3).

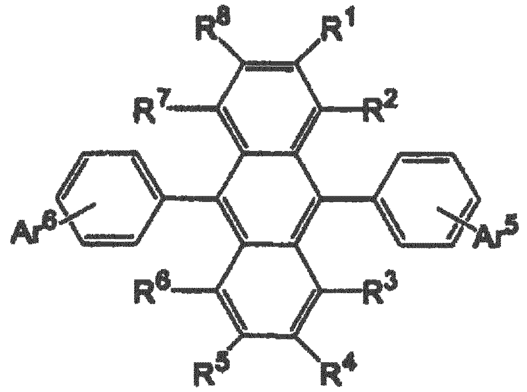

(2-6)

In the formula (2-6), $R^1$ to $R^8$ and $Ar^6$ are as defined above, and $Ar^5$ is a substituted or unsubstituted aryl group having 6 to 50 ring carbon atoms, a substituted or unsubstituted alkyl group having 1 to 50 carbon atoms, a substituted or unsubstituted cycloalkyl group having 3 to 50 ring carbon atoms, a substituted or unsubstituted aralkyl group having 7 to 50 carbon atoms or a substituted or unsubstituted heterocyclic group having 5 to 50 ring atoms, and $Ar^5$ and $Ar^6$ are independently selected.

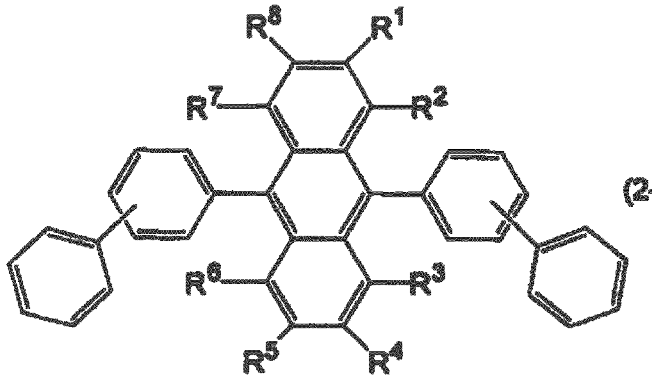

(2-6-1)

In the formula (2-6-1), $R^1$ to $R^8$ are as defined above.

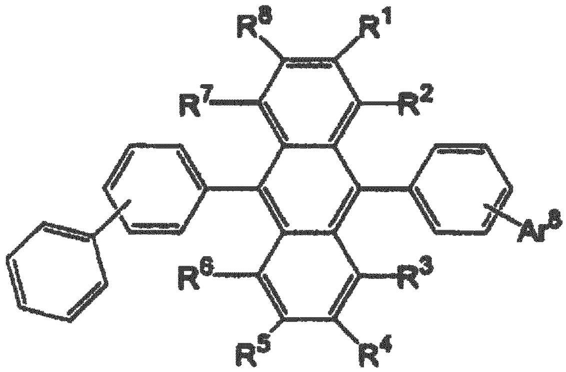

(2-6-2)

In the formula (2-6-2), $R^1$ to $R^8$ are as defined above, and $Ar^8$ is a substituted or unsubstituted fused aryl group having 10 to 20 ring carbon atoms.

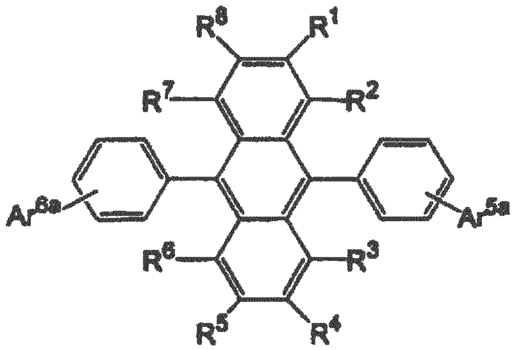

(2-6-3)

In the formula (2-6-3), $R^1$ to $R^8$ are as defined in the formula (10).
$Ar^{5a}$ and $Ar^{6a}$ are independently a substituted or unsubstituted fused aryl group having 10 to 20 ring carbon atoms.

As for the naphthalene derivative, one having the following structural formula is preferable.

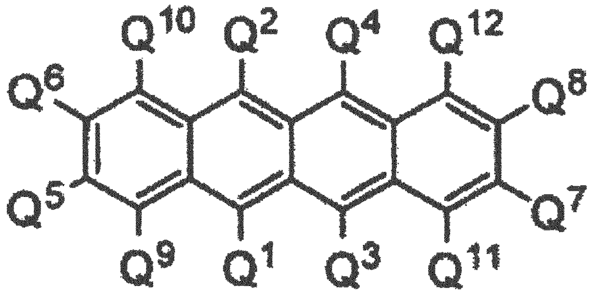

(4)

In the formula (4), $Q^1$ to $Q^{12}$ are independently a hydrogen atom, a substituted or unsubstituted alkyl group having 1 to 20 carbon atoms, a substituted or unsubstituted aryl group having 6 to 20 ring carbon atoms, an amino group, a substituted or unsubstituted alkoxy group having 1 to 20 carbon atoms, a substituted or unsubstituted alkylthio group having 1 to 20 carbon atoms, a substituted or unsubstituted aryloxy group having 6 to 20 ring carbon atoms, a substituted or unsubstituted arylthio group having 6 to 20 ring carbon atoms, a substituted or unsubstituted alkenyl group having 2 to 20 carbon atoms, a substituted or unsubstituted aralkyl group having 7 to 20 ring carbon atoms or a substituted or unsubstituted heterocyclic group having 5 to 20 ring atoms, which may be the same or different.

A compound which is represented by the formula (4) in which at least one or more of $Q^1$, $Q^2$, $Q^3$ and $Q^4$ is an aryl group is more preferable.

It is more preferred that the naphthacene derivative represented by the formula (4) is a compound represented by the following formula (5):

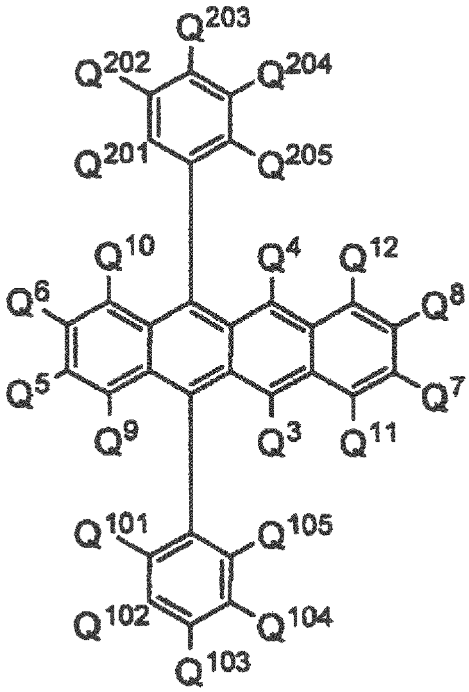

(5)

In the formula (5), $Q^3$ to $Q^{12}$, $Q^{101}$ to $Q^{105}$ and $Q^{201}$ to $Q^{205}$ are independently the same group as $Q^3$ to $Q^{12}$ in the formula (1), which may be the same or different, and adjacent two or more of these may be bonded to each other to form a ring.

It is more preferred that, in the naphthacene derivative represented by the formula (5), at least one or more of $Q^{101}$, $Q^{105}$, $Q^{201}$ and $Q^{205}$ be an alkyl group, an aryl group, an amino group, an alkoxy group, an aryloxy group, an alkylthio group, an arylthio group, an alkenyl group, an aralkyl group or a heterocyclic group, which may be the same or different

As the fluoranthene derivative, a compound represented by the following formulas [2] to [18] can be given.

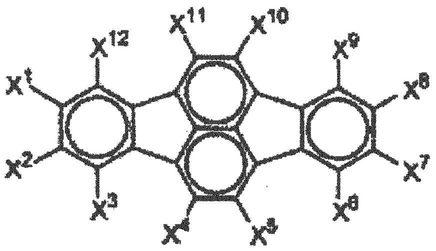

[2]

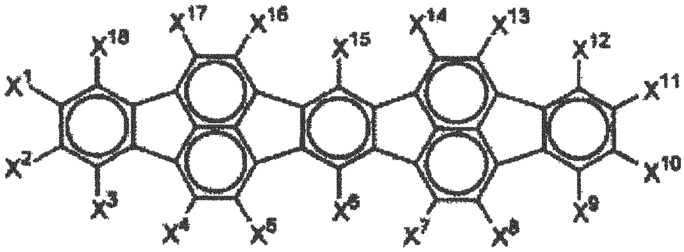

[3]

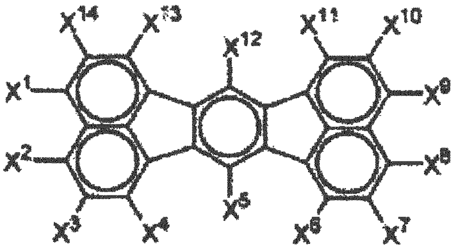

[4]

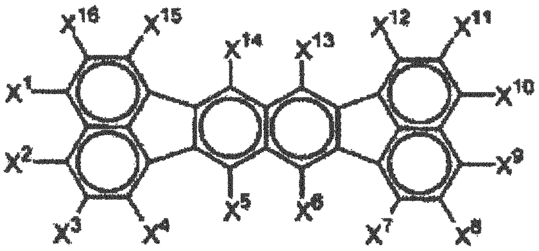

[5]

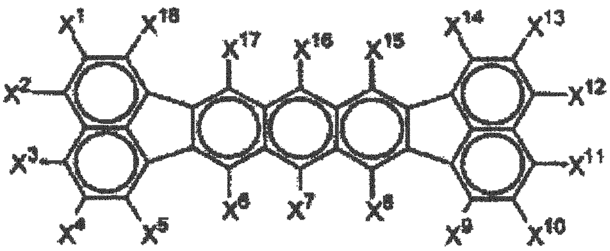

[6]

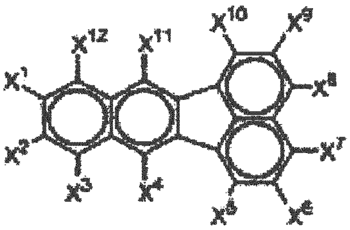

[7]

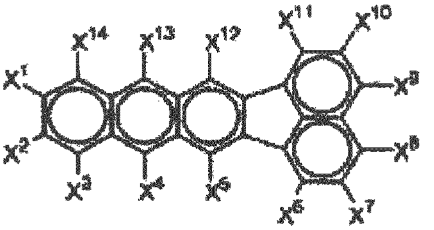

[8]

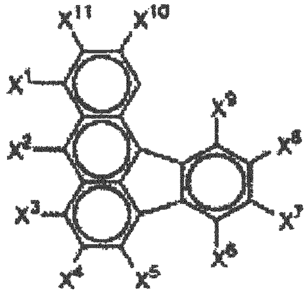

[9]

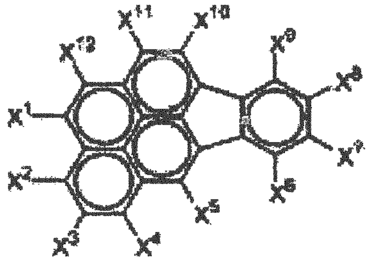

[10]

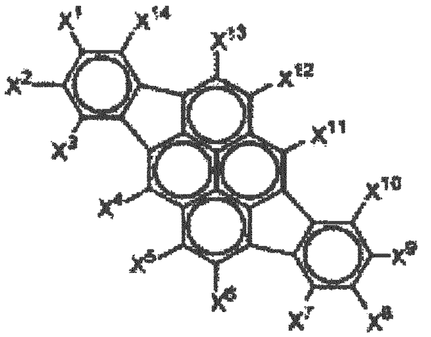

[11]

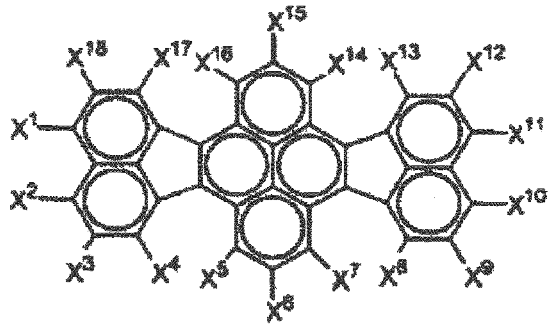

[12]

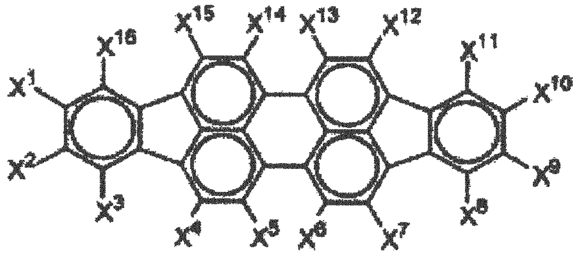

[13]

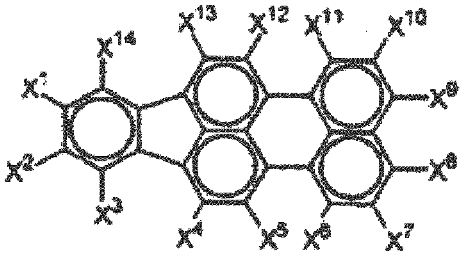

[14]

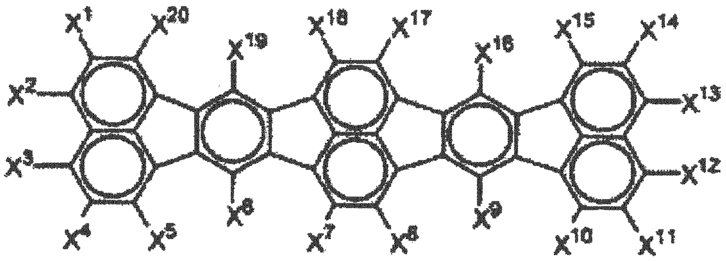

[15]

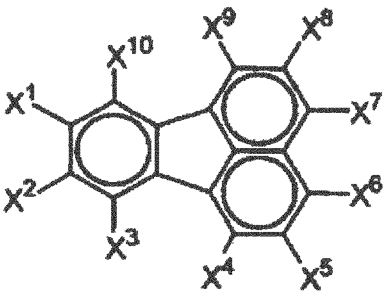

[16]

In the formulas [2] to [16], $X^1$ to $X^{20}$ are independently a hydrogen atom, a straight-chain, branched or cyclic alkyl group having 1 to 20 carbon atoms, a straight-chain, branched or cyclic alkoxy group having 1 to 20 carbon atoms, a substituted or unsubstituted aryl group having 6 to 30 carbon atoms, a substituted or unsubstituted aryloxy group having 6 to 30 carbon atoms, a substituted or unsubstituted arylamino group having 6 to 30 carbon atoms, a substituted or unsubstituted alkylamino group having 1 to 30 carbon atoms, a substituted or unsubstituted arylalkylamino group having 7 to 30 carbon atoms or a substituted or unsubstituted alkenyl group having 8 to 30 carbon atoms, and adjacent substituents and $X^1$ to $X^{20}$ may be bonded to form a ring structure. If the adjacent substituents are an aryl group, the substituents may be the same.

It is preferred that the compound represented by the formulas [2] to [16] have an amino group or an alkenyl group.

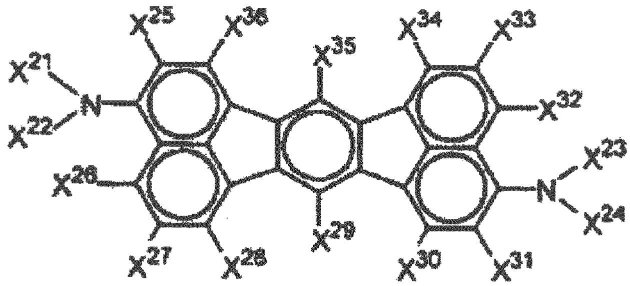

[17]

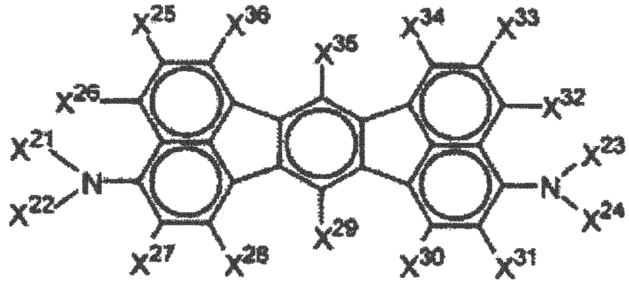

[18]

In the formulas [17] and [18], $X^{21}$ to $X^{24}$ are independently an alkyl group having 1 to 20 carbon atoms, a substituted or unsubstituted aryl group having 6 to 30 carbon atoms, and $X^{21}$ and $X^{22}$ and/or $X^{23}$ and $X^{24}$ may be bonded through a carbon-carbon bond or -O- or -S-.
$X^{25}$ to $X^{36}$ are independently a hydrogen atom, a straight-chain, branched or cyclic alkyl group having 1 to 20 carbon atoms, a straight-chain, branched or cyclic alkoxy group having 1 to 20 carbon atoms, a substituted or unsubstituted aryl group having 6 to 30 carbon atoms, a substituted or unsubstituted aryloxy group having 6 to 30 carbon atoms, a substituted or unsubstituted arylamino group having 6 to 30 carbon atoms, a substituted or unsubstituted alkylamino group having 1 to 30 carbon atoms, a substituted or unsubstituted arylalkylamino group having 7 to 30 carbon atoms, or a substituted or unsubstituted alkenyl group having 8 to 30 carbon atoms, and adjacent substituents and $X^{25}$ to $X^{36}$ may be bonded to each other to form a ring structure.
It is preferred that at least one of $X^{25}$ to $X^{36}$ have an amine group or an alkenyl group.
An indenoperylene derivative represented by the formulas [13] and [14] is preferable.

It is preferred that a fluorescent compound having a fluoranthene skeleton have an electron-donating group in order to obtain a high efficiency and a long life. Preferable electron-donating groups are substituted or unsubstituted arylamino groups. Further, it is preferred that a fluorescent compound having a fluoranthene skeleton have 5 or more fused rings, with 6 or more fused rings being particularly preferable.
Particularly preferable indenoperylene derivatives are dibenzotetraphenylperifluoranthene derivatives.

Examples of the boron complex, the pyrromethene metal complex represented by the following formula can be given.

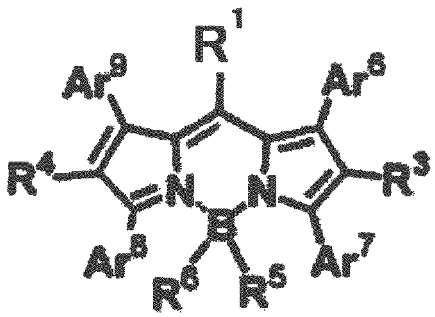

$R^1$ and $R^3$ to $R^4$ may be the same or different, and are selected from hydrogen, an alkyl group, a cycloalkyl group, an aralkyl group, an alkenyl group, a cycloalkenyl group, an alkynyl group, a hydroxyl group, a mercapto group, an alkoxy group, an alkylthio group, an arylether group, an arylthioether group, an aryl group, a heterocyclic group, halogen, haloalkane, haloalkene, haloalkyne, a cyano group, an aldehyde group, a carbonyl group, a carboxyl group, an ester

group, a carbamoyl group, an amino group, a nitro group, a silyl group and a siloxanyl group. $R^5$ and $R^6$ are both fluorine. $Ar^6$ to $Ar^{10}$ are an aryl group (as for the pyrromethene metal complex, one in which two pyrromethene groups are bonded through a linking group is excluded).

It is preferred that at least one of $Ar^6$ to $Ar^9$ be substituted byan alkyl group having 4 or more carbon atoms.

The yellowish emitting dopant can include the compound with the following structure.

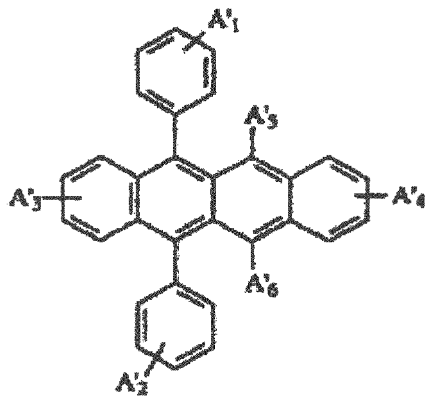

OR

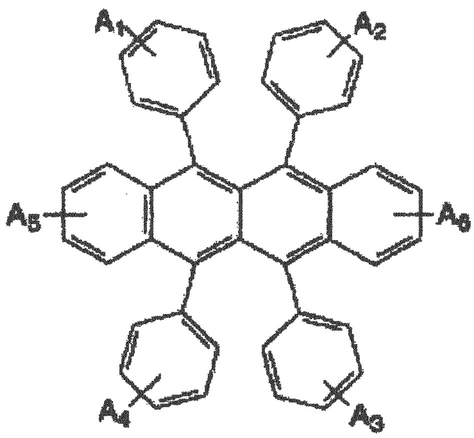

wherein $A_1$ to $A_6$ and $A'_1$ to $A'_6$ are one or more substituents in each ring, and each substituent can be selected from one of the following groups. First group: Hydrogen or alkyl having 1 to 24 carbon atoms Second group: Aryl or substituted aryl having 5 to 20 carbon atoms Third group: Hydrocarbon having 4 to 24 carbon atoms which forms a fused aromatic ring or a ring Fourth group: Heteroaryl or substituted heteroaryl having 5 to 24 carbon atoms such as thiazolyl, furyl, thienyl, pyridyl, quinolinyl or other heterocyclic groups which are bonded through a single bond or forms a fused aromatic heterocyclic group Fifth group: Alkoxylamino, alkylamino or arylamino having 1 to 24 carbon atoms Sixth group: Fluoro, chloro, bromo or cyano

Examples of the particularly effective yellow dopant are shown in USP No. 7, 252, 893 (Rick et al) or the like. Other examples of effective yellow dopant are stated in USP No. 6,818,327 and satisfy the following formula X.

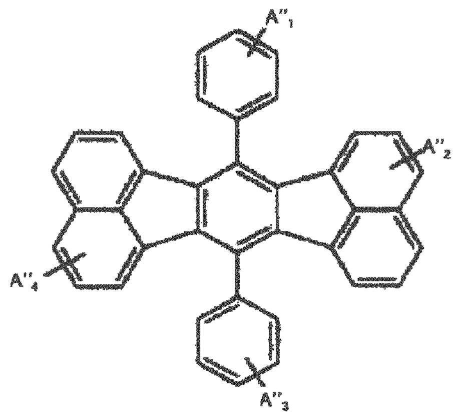

X

wherein A"$_1$ to A"$_4$ are one or more substituents in each ring, and each substituent is independently selected from one of the following groups.
First group: Hydrogen or an alkyl having 1 to 24 carbon atoms
Second group: Aryl or substituted aryl having 5 to 20 carbon atoms
Third group: Hydrocarbon having 4 to 24 carbon atoms that form a fused aromatic ring or a ring
Fourth group: Heteroaryl or substituted heteroaryl having 5 to 24 carbon atoms such as thiazolyl, furyl, thienyl, pyridyl, quinolinyl or other heterocyclic groups which are bonded through a single bond or forms a fused aromatic heterocyclic group
Fifth group: Alkoxylamino, alkylamino or arylamino having 1 to 24 carbon atoms
Sixth group: Fluoro, chloro, bromo or cyano
Particularly preferable examples are one in which A"$_1$ and A"$_3$ are hydrogen, and A"$_2$ and A"$_4$ are selected from the fifth group.

(2) Blue fluorescent emitting layer

The blue fluorescent emitting layer is an emitting layer having the maximum emitting wavelength of 400 to 500 nm, more preferably 450 to 500 nm. Preferably, the blue fluorescent emitting layer is composed of a host compound and a blue fluorescent dopant.
It is preferred that the energy gap of the host compound be larger than the energy gap of the blue dopant. As the host compound, a styryl derivative and a fused aromatic ring compound are preferable.
As the styryl derivative, a distyryl derivative, a tristyryl derivative or a tetrastyryl derivative are particularly preferable.
As the fused aromatic ring compound, an anthracene compound, a bisanthracene compound or a pyrene compound are particularly preferable.
A blue dopant having an energy gap of 2.5 to 2.7 eV is preferable. As the blue dopant, styrylamine, an amine-substituted styryl compound, a fused aromatic ring compound and a metal complex can be given. As the fused aromatic ring compound, a fluoranthene compound and a fused aromatic amine compound are preferable.
As the fused aromatic ring amine compound, an aminopyrene compound and an aminocrysene compound are preferable.
As the metal complex, a boron complex is preferable.
As the anthracene compound and the bisanthracene compound, the compounds mentioned above by referring to the red fluorescent emitting layer are preferable.
As the pyrene compound, the compounds having the following structural formula are preferable, for example.

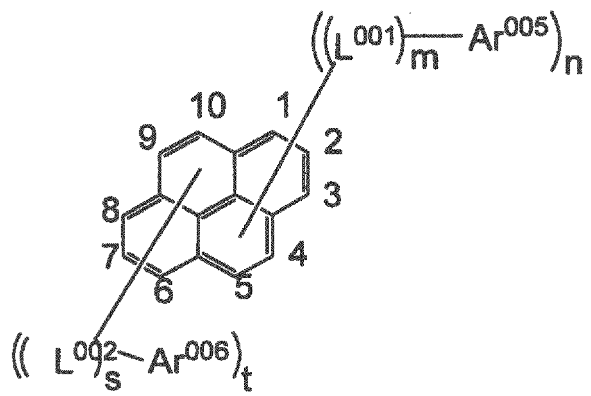

wherein $Ar^{005}$ and $Ar^{006}$ are independently a substituted or unsubstituted aromatic group having 6 to 50 ring carbon atoms. $L^{001}$ and $L^{002}$ are independently a substituted or unsubstituted phenylene group, a substituted or unsubstituted naphthalenylene group, a substituted or unsubstituted fluorenylene group or a substituted or unsubstituted dibenzosilolylene group.

m is an integer of 0 to 2, n is an integer of 1 to 4, s is an integer of 0 to 2 and t is an integer of 0 to 4.

$L^{001}$ or $Ar^{005}$ bonds to any of the 1st to the 5th positions of pyrene, and $L^{002}$ or $Ar^{006}$ bonds to any of the 6th to the 10th positions of pyrene. However, if n + t is an even number, $Ar^{005}$, $Ar^{006}$, $L^{001}$ and $L^{002}$ satisfy the following formula (1) or (2).

(1) $Ar^{005}$ # $Ar^{006}$ and/or $L^{001}$# $L^{002}$ (here, # means that they are groups having different structures)
(2) $Ar^{005}$ = $Ar^{006}$ and $L^{001}$ = $L^{002}$
(2-1) m#s and/or n#t or
(2-2) m=s and n=t
(2-2-1) $L^{001}$ and $L^{002}$ or pyrene are independently bonded to different bonding positions on $Ar^{005}$ and $Ar^{006}$; (2-2-2) $L^{001}$ and $L^{002}$ or pyrene are bonded at the same position on $Ar^{005}$ and $Ar^{006}$, provided that there is no case that the substitution position of pyrene in $L^{001}$ and $L^{002}$ or $Ar^{005}$ and $Ar^{006}$ is the 1st and the 6th positions or the 2nd and the 7th positions.

As the fluoranthene compound, the compound having the following structure is preferable.

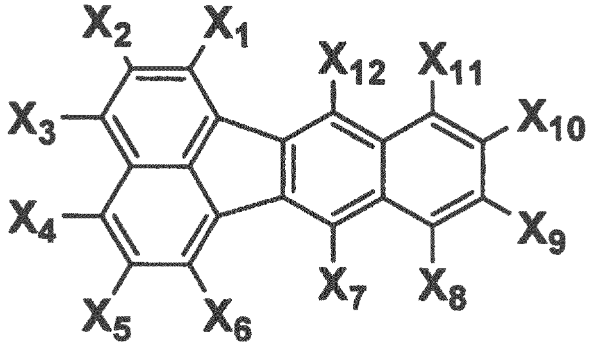

wherein $X_1$ to $X_{12}$ are hydrogen or a substituent. Preferred are compounds in which $X_1$ to $X_2$, $X_4$ to $X_6$ and $X_8$ to $X_{11}$ are hydrogen, and $X_3$, $X_7$ and $X_{12}$ are an aryl group having 5 to 50 ring atoms. More preferred are compounds in which $X_1$ to $X_2$, $X_4$ to $X_6$ and $X_8$ to $X_{11}$ are hydrogen, $X_7$ and $X_{12}$ are a substituted or unsubstituted aryl group having 5 to 50 ring atoms and $X_3$ is $-Ar_1-Ar_2$ ($Ar_1$ is a substituted or unsubstituted arylene group having 5 to 50 ring atoms and $Ar_2$ is a substituted or unsubstituted aryl group having 5 to 50 ring atoms). It is preferred that $X_1$ to $X_2$, $X_4$ to $X_6$ and $X_8$ to $X_{11}$ be a hydrogen atom, $X_7$ and $X_{12}$ be a substituted or unsubstituted aryl group having 5 to 50 ring atoms and $X_3$ be $-Ar_1-Ar_2-Ar_3$ ($Ar_1$ and $Ar_3$ are independently a substituted or unsubstituted arylene group having 5 to 50 ring atoms and $Ar_2$ is a substituted or unsubstituted aryl group having 5 to 50 ring atoms).

As the aminopyrene compound, the compound represented by the following formula is preferable, for example.

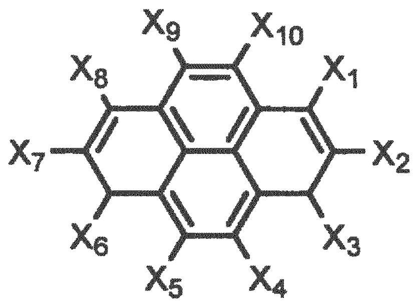

$X_{1-10}$ are independently H or a substituent, provided that $X_3$ and $X_8$ or $X_2$ and $X_7$ are independently $-NY_1Y_2$ ($Y_1$ are $Y_2$ are substituents). It is preferred that, when $X_3$ and $X_8$ be $-NY_1Y_2$, $X_{2, 4, 5, 7, 9, 10}$ are H, and $X_1$ and $X_6$ are hydrogen, alkyl or cycloalkyl. Preferable is an aminopyrene compound in which, when $X_2$ and $X_7$ are independently $-NY_1Y_2$, $X_{1,3-6, 8-10}$ are H. It is preferred that $Y_1$ and $Y_2$ be a substituted (for example, C1-6 alkyl) or unsubstituted aromatic ring (phenyl, naphthyl, for example).

As the aminochrysene compound, the compounds having the following configuration are preferable. Specific examples of the aminochrysene derivative include the following:

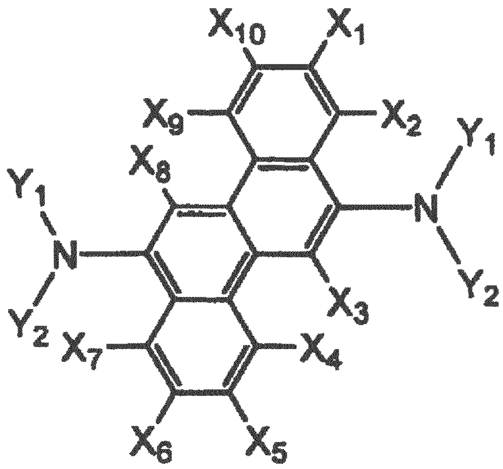

$X_1$ to $X_{10}$ are independently hydrogen or a substituent, and $Y_1$ and $Y_2$ are independently a substituent. Preferably, $X_1$ to $X_{10}$ are hydrogen. It is preferred that $Y_1$ and $Y_2$ be a substituted (preferably substituted by a C1-6 alkyl) or an unsubstituted C6-30 aromatic ring (preferably C6-10 or phenyl).

As the boron complex, the complex represented by the following structural formula is preferable.

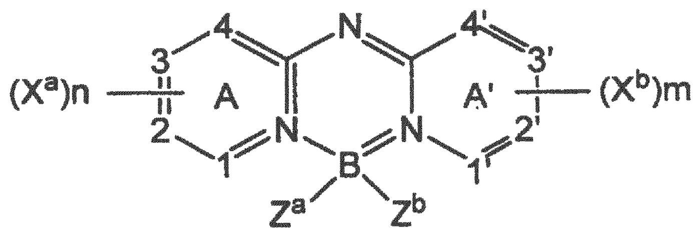

wherein A and A' are an independent azine ring corresponding to the six-membered aromatic ring containing at least one nitrogen; $X^a$ and $X^b$ are independently a selected substituent and form a fused ring relative to the ring A or the ring A' by bonding, the fused ring includes an aryl or a heteroaryl substituent, m and n are independently 0 to 4, $Z^a$ and $Z^b$ are independently a selected halide, and 1, 2, 3, 4, 1', 2', 3' and 4' are independently a selected carbon atom or a nitrogen atom.

It is desirable that, the azine ring be a quinolynyl ring or an isoquinolynyl ring in which 1, 2, 3, 4, 1', 2', 3' and 4' are all carbon atoms, m and n are 2 or more and $X^a$ and $X^b$ are substituents having two or more carbon atoms which are bonded to each other to form an aromatic ring. It is preferred that $Z^a$ and $Z^b$ be a fluorine atom.

(3) Green phosphorescent emitting layer

The green phosphorescent emitting layer is preferably an emitting layer having a maximum emission wavelength of 500 nm to less than 570 nm, more preferably 510 to 550 nm. It is preferred that the green phosphorescent emitting layer be composed of a host compound and a green phosphorescent dopant. It is preferred that the energy gap of the host compound be larger than the energy gap of the green dopant. As the host compound, a material having a triplet energy gap of 2.5 eV or more is preferable. For example, a compound containing a hetero ring can be given. As the compound containing a hetero ring, a carbazole compound, an azacarbazole compound or the like can be given.

As the dopant, one having an energy gap of 1.9 to 2.3 eV is preferable. As the dopant, an organic metal complex is preferable.

As the organic metal complex, an organic metal complex having a metal element selected from Ir, Pt, Os, Cu, Ru and Re as the central element is preferable, in respect of luminous efficiency or the like.

An organic metal complex formed of a ligand selected from phenylquinoline, phenylisoquinoline, phenylpyridine, phenylpyrimidine, phenylpyrazine and phenylimidazole is preferable.

As the carbazole compound and the azacarbazole compound, the following structures can be given.

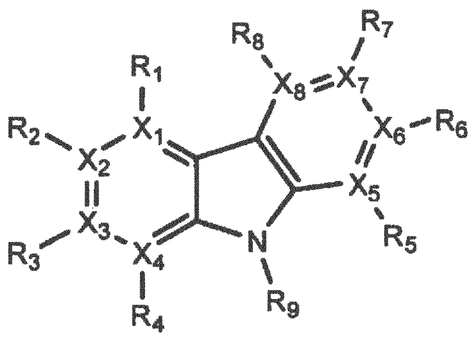

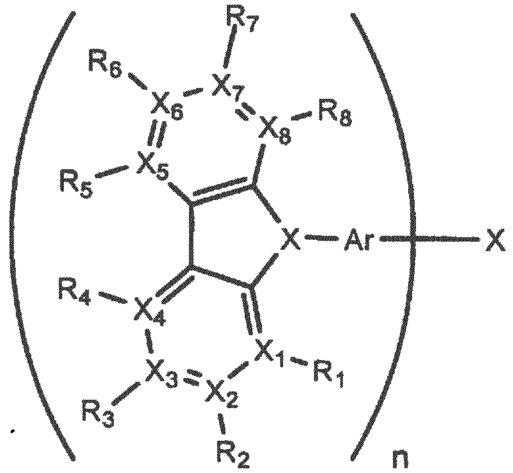

In the above formula, n is 2 or 3, $X_1R_1$ to $X_8R_8$ are independently N or CR, R($R_1$-$R_8$) is a substituent, and represents a hydrogen atom, an alkyl group, an aralkyl group, an alkenyl group or an aromatic hydrocarbon group having a substituent Ar is a substituted or unsubstituted aromatic group, X is a linking group, N, a substituted or unsubstituted aromatic group or CR. R is a substituent, and represents a hydrogen atom, an alkyl group, an aralkyl group, an alkenyl group, an aromatic hydrocarbon group which may have a substituent or an aromatic heterocyclic group which may have a substituent In the above-formula, Ar and Ar may be directly bonded.

Specific examples of the compound are shown below.

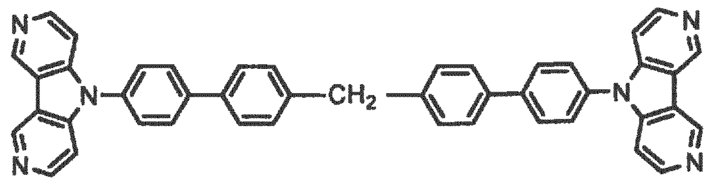

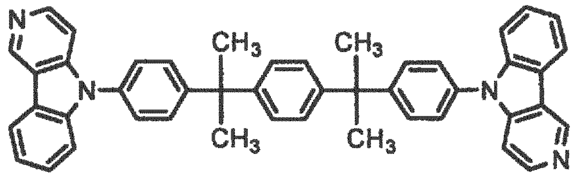

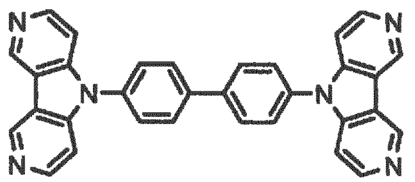

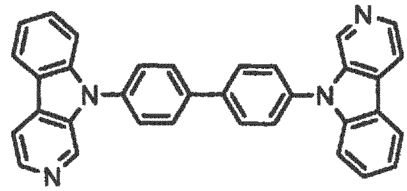

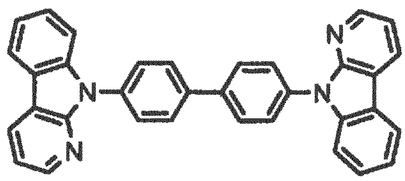

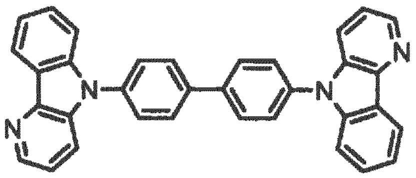

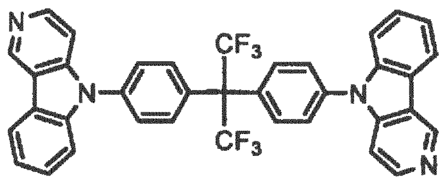

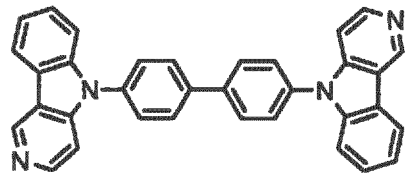

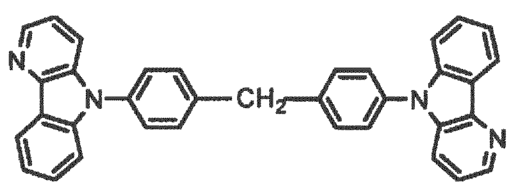

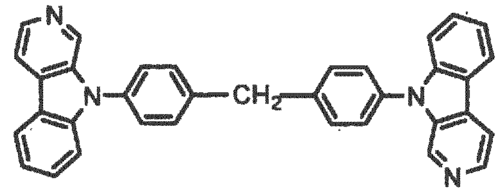

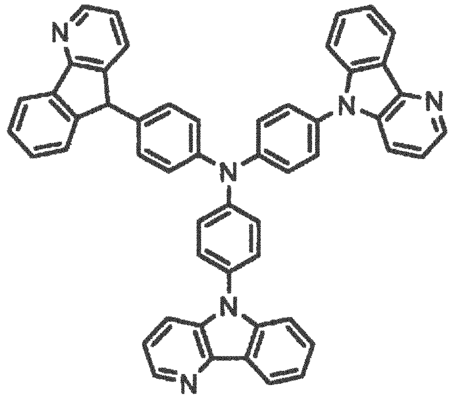

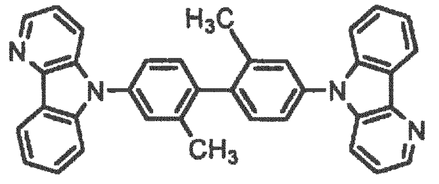

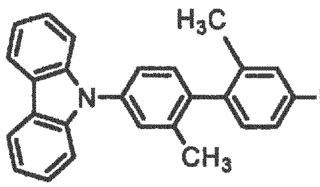

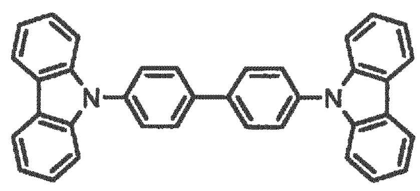

As the other compound containing a hetero ring, the following structure (ladder) can be exemplified.

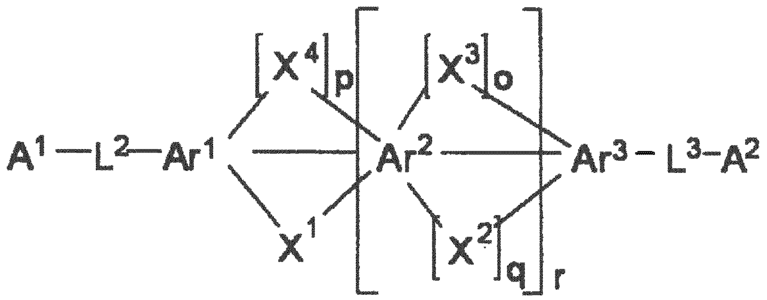

···(1)

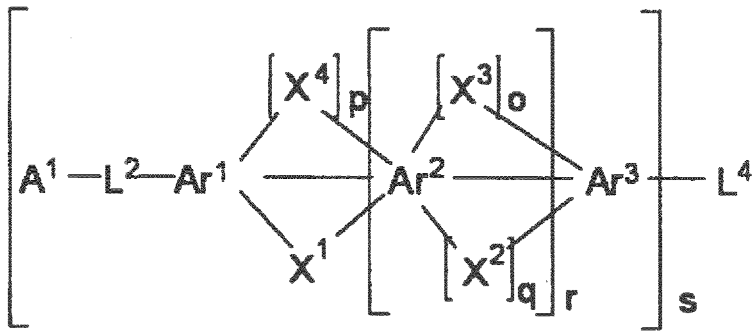

···(2)

In the formulas (1) and (2), $Ar^1$, $Ar^2$ and $Ar^3$ are independently a substituted or unsubstituted aromatic hydrocarbon group having 6 ring carbon atoms or a substituted or unsubstituted aromatic heterocyclic group having 6 ring atoms. $Ar^1$, $Ar^2$ and $Ar^3$ may have one or a plurality of substituent Y. If $Ar^1$, $Ar^2$ and $Ar^3$ have a plurality of substituent Y, the substituents Y may be different from each other. Y is an alkyl group having an alkyl group having 1 to 20 carbon atoms, a substituted or unsubstituted cycloalkyl group having 3 to 20 ring carbon atoms, an alkoxy group having 1 to 20 carbon atoms, an aralkyl group having 7 to 24 carbon atoms, a silyl group or a substituted silyl group having 3 to 20 carbon atoms, a substituted or unsubstituted aromatic hydrocarbon group or a fused aromatic hydrocarbon group having 6 to 24 ring carbon atoms or a substituted or unsubstituted aromatic heterocyclic group or a fused aromatic heterocyclic group having 3 to 24 ring carbon atoms.

In the formulas (1) and (2), $X^1$, $X^2$, $X^3$ and $X^4$ are independently oxygen (O), sulfur (S), N-$R_1$ or $CR_2R_3$. $R_1$, $R_2$ and $R_3$ are independently an alkyl group having 1 to 20 carbon atoms, a substituted or unsubstituted cycloalkyl group having 3 to 20 ring carbon atoms, an aralkyl group having 7 to 24 carbon atoms, a silyl group or a substituted silyl group having 3 to 20 carbon atoms, a substituted or unsubstituted aromatic hydrocarbon group or a fused aromatic hydrocarbon group having 6 to 24 ring carbon atoms or a substituted or unsubstituted aromatic heterocyclic group or a fused aromatic heterocyclic group having 3 to 24 ring carbon atoms.
If $X^1$ and $X^2$ are both N-$R_1$, o and p are 0 and q is 1, or if $X^1$ and $X^3$ are both N-$R_1$, p and q is 0 and o is 1, at least one of $R_1$s is a substituted or unsubstituted monovalent fused aromatic heterocyclic group having 8 to 24 ring atoms.

In the formulas (1) and (2), o, p and q represent 0 or 1. s is 1, 2, 3 or 4. They are independently a monomer, a dimer, a trimer or a tetramer which is linked through $L^4$. r is 1, 2, 3 or 4.

In the formulas (1) and (2), $L^2$ is a single bond, an alkylene group having 1 to 20 carbon atoms, a substituted or unsubstituted cycloalkylene group having 3 to 20 ring carbon atoms, a divalent silyl group or a substituted divalent silyl group having 2 to 20 carbon atoms, a substituted or unsubstituted divalent aromatic hydrocarbon group or a substituted or unsubstituted fused aromatic hydrocarbon group having 6 to 24 ring carbon atoms or a substituted or unsubstituted monovalent or divalent aromatic heterocyclic group or a fused heterocyclic ring group having 3 to 24 ring carbon atoms.

In the formula (1), $L^3$ is a single bond, an alkylene group having 1 to 20 carbon atoms, a substituted or unsubstituted cycloalkylene group having 3 to 20 ring carbon atoms, a divalent silyl group or a substituted divalent silyl group having 2 to 20 carbon atoms, a substituted or unsubstituted divalent aromatic hydrocarbon group or divalent fused aromatic hydrocarbon group having 6 to 24 ring carbon atoms or a substituted or unsubstituted divalent aromatic heterocyclic group or fused aromatic heterocyclic group having 3 to 24 ring carbon atoms.

In the formula (2), $L^4$ is, when s is 2, a single bond, an alkylene group having 1 to 20 carbon atoms, a substituted or unsubstituted cycloalkylene group having 3 to 20 ring carbon atoms, a divalent silyl group or a divalent substituted silyl group having 2 to 20 carbon atoms, a substituted or unsubstituted divalent aromatic hydrocarbon group or fused aromatic hydrocarbon group having 6 to 24 ring carbon atoms or a divalent aromatic heterocyclic group or fused aromatic heterocyclic group having 3 to 24 ring carbon atoms.

When s is 3, $L^4$ is a trivalent saturated hydrocarbon group having 1 to 20 carbon atoms, a substituted or unsubstituted trivalent cyclic saturated hydrocarbon group having 3 to 20 ring carbon atoms, a trivalent silyl group or a trivalent substituted silyl group having 1 to 20 carbon atoms, a substituted or unsubstituted trivalent aromatic hydrocarbon group or fused aromatic hydrocarbon group having 6 to 24 ring carbon atoms or a substituted or unsubstituted trivalent aromatic heterocyclic group having 3 to 24 ring carbon atoms.

When s is 4, $L^4$ is a tetravalent saturated hydrocarbon group having 1 to 20 carbon atoms, a substituted or unsubstituted tetravalent cyclic saturated hydrocarbon group having 3 to 20 ring carbon atoms, a silicon atom, a substituted or unsubstituted tetravalent aromatic hydrocarbon group or fused aromatic hydrocarbon group having 6 to 24 ring carbon atoms or a substituted or unsubstituted tetravalent aromatic heterocyclic group or fused aromatic heterocyclic group having 3 to 24 ring carbon atoms.

In the formulas (1) and (2), $A^1$ is a hydrogen atom, a substituted or unsubstituted cycloalkyl group having 3 to 20 ring carbon atoms, a silyl group or a substituted silyl group having 3 to 20 carbon atoms, a substituted or unsubstituted aromatic hydrocarbon group or fused aromatic hydrocarbon group having 6 to 24 ring carbon atoms or a substituted or unsubstituted aromatic heterocyclic group or fused aromatic heterocyclic group having 3 to 24 ring carbon atoms.

In the formula (1), $A^2$ is a hydrogen atom, a substituted or unsubstituted cycloalkyl group having 3 to 20 ring carbon atoms, a silyl group or a substituted silyl group having 3 to 20 carbon atoms, a substituted or unsubstituted aromatic hydrocarbon group or fused aromatic hydrocarbon group having 6 to 24 ring carbon atoms or a substituted or unsubstituted aromatic heterocyclic group or fused aromatic heterocyclic group having 3 to 24 ring carbon atoms.

A compound in which one of $X^1$ and $X^4$ or one of $X^2$ and $X^3$ in the formulas (1) and (2) is an oxygen atom and has a dibenzofuran structure in its molecule is preferable.

Further, a compound in which one of $X^1$ and $X^4$ and one of $X^2$ and $X^3$ in the formulas (1) and (2) are both an oxygen atom has a benzofuranodibenzofuran structure is preferable.

As the other compound, containing a hetero ring the following structure (biscarbazole) can be exemplified.

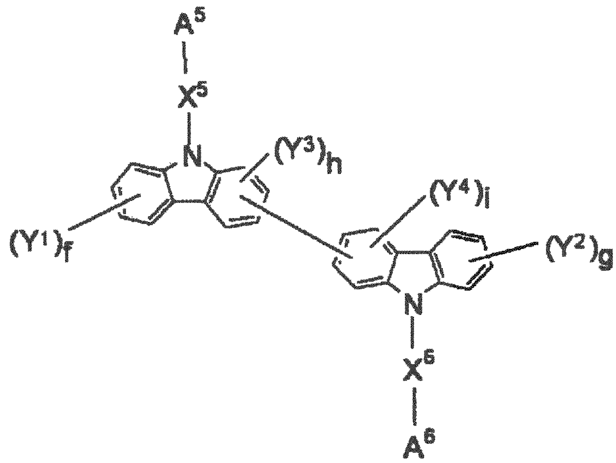

In the above formula, $A^5$ is a substituted or unsubstituted nitrogen-containing heterocyclic group having 1 to 30 ring carbon atoms (however, a substituted or unsubstituted carbazolyl group and a substituted or unsubstituted indolyl group are excluded).

$A^6$ is a substituted or unsubstituted aromatic hydrocarbon group or fused aromatic hydrocarbon group having 6 to 30 ring carbon atoms or a substituted or unsubstituted nitrogen-containing heterocyclic group having 1 to 30 ring carbon atoms.

$X^5$ and $X^6$ are linking groups, and are independently a single bond, a substituted or unsubstituted aromatic hydrocarbon group having 6 to 30 ring carbon atoms, a substituted or unsubstituted fused aromatic hydrocarbon group having 6 to 30 ring carbon atoms, a substituted or unsubstituted aromatic heterocyclic group having 2 to 30 ring carbon atoms or a

substituted or unsubstituted fused aromatic heterocyclic group having 2 to 30 ring carbon atoms.

$Y^1$ to $Y^4$ are independently a hydrogen atom, a fluorine atom, a cyano group, a substituted or un substituted alkyl group having 1 to 20 carbon atoms, a substituted or unsubstituted alkoxy group having 1 to 20 carbon atoms, a substituted or unsubstituted haloalkyl group having 1 to 20 carbon atoms, a substituted or unsubstituted haloalkoxy group having 1 to 20 carbon atoms, a substituted or unsubstituted alkylsilyl group having 1 to 10 carbon atoms, a substituted or unsubstituted arylsilyl group having 6 to 30 carbon atoms, a substituted or unsubstituted aromatic hydrocarbon group having 6 to 30 ring carbon atoms, a substituted or unsubstituted fused aromatic hydrocarbon group having 6 to 30 ring carbon atoms, a substituted or unsubstituted aromatic heterocyclic group having 2 to 30 ring carbon atoms or a substituted or unsubstituted fused aromatic heterocyclic group having 2 to 30 ring carbon atoms.

Adjacent groups of $Y^1$ to $Y^4$ may be bonded each other to form a ring structure.

f and g are an integer of 1 to 4, and h and i are an integer of 1 to 3.

If f and g are an integer of 2 to 4, h and i are an integer of 2 to 3, plural $Y^1$ to $Y^4$ may be the same or different.

(4) Red phosphorescent emitting layer

The red phosphorescent emitting layer is preferably an emitting layer having the maximum emission wavelength of 570 to 700 nm, more preferably 570 to 650 nm. The red color includes yellow. The red phosphorescent emitting layer is preferably composed of a host compound and a red phosphorescent dopant. It is preferred that the triplet energy gap of the host compound be larger than the triplet energy gap of the red dopant. As the host compound, materials exemplified as the host compound in the green phosphorescent emitting layer, organic metal complexes, polycyclic fused aromatic ring compound or an amine compound are preferable.

As the dopant, one having a triplet energy gap of 1.9 to 2.3 eV is preferable. As the dopant, an organic metal complex is preferable.

As the organic metal complex, an organic metal complex containing a metal element selected from Ir, Pt, Os, Cu, Ru and Re as the central metal is preferable in respect of luminous efficiency or the like.

Further, in respect of luminous efficiency or the like, an organic metal complex composed of ligands selected from phenylquinoline, phenylisoquinoline, phenylpyridine, phenylpyrimidine, phenylpyrazine and phenylimidazole is preferable.

As the organic metal complex, the following structure can be given.

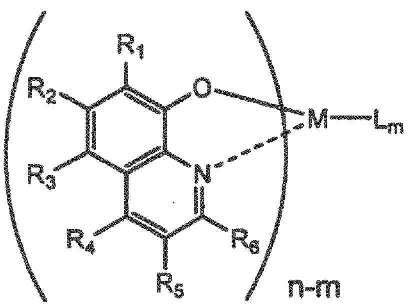

In the above formula, when n is 2, M is a divent metal ion (magnesium, zinc, cupper, palladium, platinum, gold), when n is 3, M is a trivalent metal ion (aluminum, yttrium, scandium, rare earth metals), $R_1$ to $R_6$ are independently a hydrogen atom, an alkyl group, an aralykyl group, an alkenyl group, a cyano group, an amino group, an amide group, an alkoxycarbonyl group, a carboxyl group, an alkoxy group, an aromatic hydrocarbon group which may have a substituent or an aromatic heterocyclic group which may have a substituent.

m is 0 or 1, when m is 1, L is any of the followings:

$-O-Ar_1$

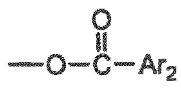

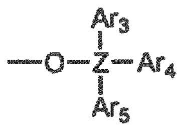

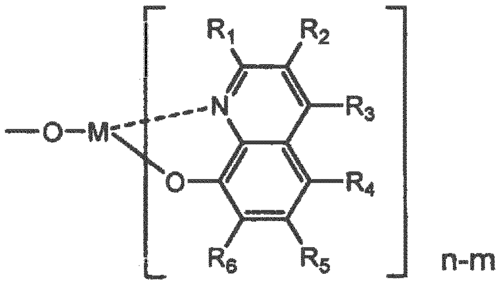

$Ar_1$ to $Ar_5$ are independently an aromatic hydrocarbon ring group which may have a substituent or an aromatic heterocyclic group which may have a substituent, Z is silicon or germanium, $R_1$ to $R_6$ are independently a hydrogen atom, an alkyl group, an aralkyl group, an alkenyl group, a cyano group, an amino group, an amide group, an alkoxycarbonyl group, a carboxyl group, an alkoxy group, an aromatic hydrocarbon group which may have a substituent or an aromatic heterocyclic group which may have a substituent.

As the polycyclic fused aromatic ring compound, fused aromatic compounds represented by the following formula (11) or (12) are exemplified.

Ara-Arb-Arc.... (11)

Ard-Are-Arf-Arg... (12)

Ara, Arb, Arc, Ard, Are, Arf and Arg are independently a group which is induced from a benzene skeleton which may have a substituent, a naphthalene skeleton which may have a substituent and a fused aromatic hydrocarbon skeleton which has three or more rings and may have a substituent.

If each of Ara, Arb, Ars, Arc, Ard, Are, Arf and Arg has a substituent, as the substituent, an alkyl group having 1 to 20 carbon atoms, a haloalkyl group having 1 to 20 carbon atoms, a cycloalkyl group having 3 to 18 carbon atoms, an aryl group having 6 to 30 ring carbon atoms, a silyl group having 3 to 20 carbon atoms, a cyano group or a halogen atom is preferable, for example.

As the alkyl group, a methyl group, an ethyl group, a propyl group, an isopropyl group, an n-butyl group, a 1-methylpropyl group, and a 1-propylbutyl group can be given.

As the haloalkyl group, a 2,2,2-trifluoroethyl group can be given, for example.

As the cycloalkyl group, a cyclopropyl group, a cyclobutyl group, a cyclopentyl group, a cyclohexyl group and a cyclooctyl group can be given, for example.

As the aryl group, the same groups as those for $Ar^1$ mentioned below can be given.

As the silyl group, a trimethylsilyl group and a triethylsilyl group can be given, for example. As the halogen atom, fluorine, chlorine, bromine and iodine can be given, for example.

The case where Ara, Arb, Arc, Ard, Are, Arf and Arg do not have a substituent means a case where a hydrogen atom is substituted. The hydrogen atom includes protium and deuterium.

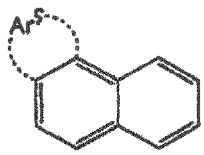

···(13)

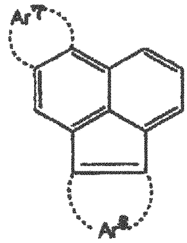

···(15)

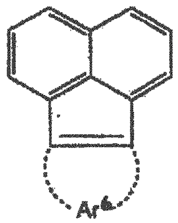

···(14)

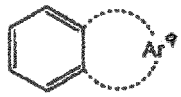

···(16)

In the formulas (13) to (16), $Ar^5$ to $Ar^9$ are independently a ring structure having 4 to 20 ring carbon atoms which may have a substituent and forms a fused ring with adjacent rings.
In the formula (11) or (12), it is preferred that the fused aromatic hydrocarbon skeleton having 3 or more rings be any of a phenanthrene skeleton, a benzophenanthrene skeleton, a dibenzophenanthrene skeleton, a chrysene skeleton, a benzochrysene skeleton, dibenzochorysene skeleton, a fluoranthene skeleton, a benzofluoranthene skeleton, a triphenylene skeleton, a benzotriphenylene skeleton, a dibenzotriphenylene skeleton, a picene skeleton, a benzopicene skeleton and a dibenzopicene skeleton. In particular, a fused aromatic hydrocarbon compound having a fluoranthene skeleton or a phenanthrene skeleton is preferable.

(5) Intermediate Unit

An intermediate unit is a layer including an intermediate conductive layer and/or a charge-generating layer or an intermediate conductive layer and/or a charge-generating layer, and serves as the supply source of electrons or holes to be injected into the emission unit. In addition to charges injected from a pair of electrodes, charges supplied from the intermediate unit are also injected into the emitting unit. Accordingly, by providing an intermediate unit, luminous efficiency (current efficiency) relative to the injected current is improved.
As the intermediate unit, a metal, a metal oxide, a mixture of metal oxides, composite oxides and an electron-accepting organic compound can be given. As the metal, Mg, Al, a co-deposition film of Mg orAg is preferable. As the metal oxide, ZnO, $WO_3$, $MoO_3$ and $MoO_2$ can be given. As the mixture of metal oxides, ITO or IZO, ZnO:Al or the like can be given. As the electron-accepting organic compound, an organic compound having a CN group as a substituent can be given. As the organic compound having a CN group, a triphenylene derivative, a tetracyanoquinodimetane derivative, an indenofluorene derivative or the like are preferable. As the triphenylene derivative, hexacyanohexazatriphenylene is preferable. As the tetracycnoquinodimethane derivative, tetrafluoroquinodimethane and dicyanoquinodimethane are preferable. As the indenofluorenene derivative, compounds disclosed in WO2009/011327, WO2009/069717 or WO2010/064655 are preferable. The electron-accepting material may be a single material or a mixture with other organic compounds.
Preferably, in order to facilitate receiving of electrons from the charge-generating layer, the vicinity of the charge-generating layer interface in the electron-transporting layer is doped with a donar represented by an alkaline metal is doped. As the donar, it is possible to select at least one selected from the group consisting of a donar metal, a donar metal compound and a donar metal complex.
As the specific examples of the compound used as the donar metal, the donar metal compound and the donar metal complex, compounds mentioned in Patent Application No. PCT/JP2010/003434 can be given.

(6) Blocking layer

The blocking layer has a role of preventing diffusion of triplet excitons generated in the emitting layer to an electron-transporting region and of injecting electrons to the emitting layer efficiently. If the electron-injection property to the emitting layer is lowered, the density of the triplet excitons is decreased by the reduction of electron-hole recombination. If the density of the triplet excitons is decreased, the frequency of collision of triplet excitons is decreased, and as a result, a TTF phenomenon does not occur efficiently. In respect of efficient electron injection to the emitting layer, the following two morphologies can be considered as the morphology of the electron-transporting region including the blocking layer.
(i) Allowing the electron-transporting region to be a stacked structure of two or more different materials, and providing an electron-injecting layer between the blocking layer and the cathode for efficiently receiving electrons from the cathode. Specific examples of the electron-injecting layer, a nitrogen-containing heterocyclic derivative or the like can be given.
In this case, it is preferred that the affinity of the electron-injecting layer Ae - the affinity of the blocking layer Ab < 0.2 eV. If these conditions are not satisfied, electron injection from the electron-injecting layer to the blocking layer is deteriorated, and as a result, electrons are accumulated in the electron-transporting region to increase the voltage. At the same time, accumulated electrons collide with the triplet excitons to cause energy quenching.
Here, it is preferred that the electron mobility of the material constituting the blocking layer be $10^{-6}$ $cm^2/Vs$ or more in the range of an electric field intensity of 0.04 to 0.5 MV/cm.
Further, it is preferred that the electron mobility of the material constituting the electron-injecting layer be $10^{-6}$ $cm^2/Vs$ or more in the range of an electric field intensity of 0.04 to 0.5 MV/cm. The reason therefor is that, by this range, injection of electrons to the emitting layer is promoted to increase the density of excitons in the emitting layer, whereby a TTF phenomenon is caused to occur efficiently.

(ii) Allowing an electron-transporting region to be formed of one blocking layer. In order to facilitate receiving of electrons from the cathode, the vicinity of the cathode interface in the blocking layer is doped with a donar represented by an alkaline metal. As the donar, it is possible to select at least one selected from the group consisting of a donar metal, a donar metal compound and a donar metal complex.

The donar metal means a metal having a work function of 3.8 eV or less. Preferable donar metals include alkaline metals, alkaline earth metals and rare earth metals. More preferable donar metals are Cs, Li, Na, Sr, K, Mg, Ca, Ba, Yb, Eu and Ce.
The donar metal compounds mean compounds that contain the above-mentioned donar metals. Preferable donar metal compounds include compounds including an alkali metal, an alkaline earth metal or a rare earth metal. More preferably, halides, oxides, carbonates and borates of these metals can be given. For example, a compound represented by MOx (x is a donar metal, x is 0.5 to 1.5), MFx (x is 1 to 3), and $M(CO_3)x$ (x is 0.5 to 1.5) is given.

The donar metal complex is a complex of the above-mentioned donar metals. Preferable donar metal complexes are organic metal complexes of an alkaline metal, an alkaline earth metal or a rare earth metal. An organic metal complex represented by the following formula is preferable.

$$M-(Q)_n$$

wherein M is a donar metal, Q is a ligand (preferably, a carboxylic acid derivative, a diketone derivative or a quinoline derivative and n is an integer of 1 to 4).

Specific examples of the donar metal complex include a tungsten wheel described in JP-A-2005-72012. Further, a phthalocyanine compound having an alkaline metal or an alkaline earth metal as the central metal or the like disclosed in JP-A-H11-345687 can be used as a donar metal complex.
The above-mentioned donar may be used singly or in combination of two or more.

In the invention, density of excitons in the interface between the emitting layer and the blocking layer is large. In this case, possibility that holes which do not contribute to the recombination in the emitting layer are injected to the blocking layer is increased. Therefore, as the material used in the blocking layer, a material having excellent oxidation resistance is preferable.

Specific examples of the material having excellent oxidation resistance include aromatic hydrocarbon compounds, in particular, one or more compounds selected from the group consisting of the polycyclic aromatic compounds represented by the following formulas (A), (B) and (C) disclosed in the Japanese Patent Application No. 2009-090379.

$$Ra\text{-}Ar^{101}\text{-}Rb \qquad (A)$$

$$Ra\text{-}Ar^{101}\text{-}Ar^{102}\text{-}Rb \qquad (B)$$

$$Ra\text{-}Ar^{101}\text{-}Ar^{102}\text{-}Ar^{103}\text{-}Rb \qquad (C)$$

In the formula, $Ar^{101}$, $Ar^{102}$, $Ar^{103}$, Ra and Rb are independently a polycyclic aromatic skeleton part selected from a substituted or unsubstituted benzene ring, a substituted or unsubstituted naphthalene ring, a substituted or unsubstituted chrysene ring, a substituted or unsubstituted fluoranthene ring, a substituted or unsubstituted phenanthrene ring, a substituted or unsubstituted benzophenanthrene ring, a substituted or unsubstituted dibenzophenanthrene ring,

a substituted or unsubstituted triphenylene ring, a substituted or unsubstituted benzo[a]triphenylene ring, a substituted or unsubstituted benzochrysene ring, a substituted or unsubstituted benzo[b]fluoranthene ring, a substituted or unsubstituted fluorene ring and a substituted or unsubstituted picene ring. However, the substituent of Ra and Rb is not an aryl group. There are no cases that $Ar^1$, $Ar^2$, $Ar^3$, Ra and Rb are simultaneously a substituted or unsubstituted benzene ring.

In the above-mentioned polycyclic aromatic compound, it is preferred that one of Ra and Rb or both of Ra and Rb be selected from a substituted or unsubstituted phenanthrene ring, a substituted or unsubstituted benzo[c]phenanthrene ring a substituted or unsubstituted fluoranthene ring.

The polycyclic aromatic skeleton part of the above-mentioned polycyclic compound may have a substituent. As the substituent of the polycyclic aromatic skeleton part, a halogen atom, a hydroxyl group, a substituted or unsubstituted amino group, a nitro group, a cyano group, a substituted or unsubstituted alkyl group, a substituted or unsubstituted alkenyl group, a substituted or unsubstituted cycloalkyl group, a substituted or unsubstituted alkoxy group, a substituted or unsubstituted aromatic hydrocarbon group, a substituted or unsubstituted aromatic heterocyclic group, a substituted or unsubstituted aralkyl group, a substituted or unsubstituted aryloxy group, a substituted or unsubstituted alkoxycarbonyl group or a carboxyl group. Preferred examples of the aromatic hydrocarbon group include naphthalene, phenanthrene, fluorene, chrysene, fluoranthene and triphenylene. If the polycyclic aromatic skeleton part has a plurality of substituents, they may form a ring.

It is preferred that the polycyclic aromatic skeleton part compound be one selected from compounds represented by the following formulas (1) to (4):

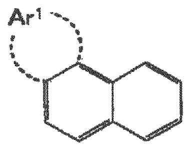

··· (1)

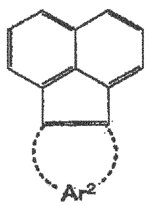

··· (2)

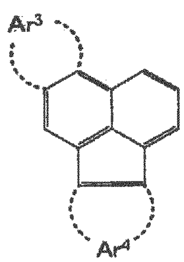

··· (3)

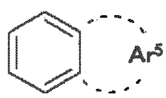

··· (4)

In the formulas (1) to (4), $Ar^1$ to $Ar^5$ each represent a substituted or unsubstituted fused ring structure having 4 to 16 ring carbon atoms.

As the compounds represented by the formula (1), a substituted or unsubstituted phenanthrene, a single body of chrysene or derivatives thereof or the like can be given.

As the compounds represented by the formula (2), a substituted or unsubstituted acenaphthylene, acenaphthene, a single body of fluoranthene or derivatives thereof or the like can be given.

As the compounds represented by the formula (3), a single body of substituted or unsubstituted benzofluoronaphthalene or derivatives thereof or the like can be given.

As the compounds represented by the formula (4), a single body of substituted or unsubstituted naphthalene or derivatives

thereof or the like can be given.

As the naphthalene derivatives, one represented by the following formula (4A) can be given, for example.

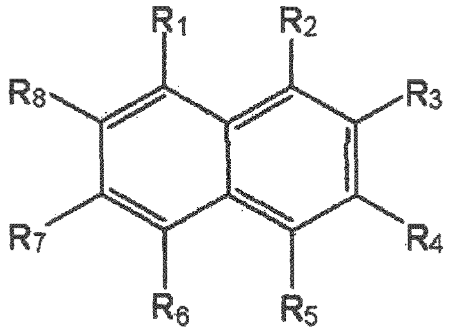

... (4A)

In the formula (4A), $R_1$ to $R_8$ are independently a hydrogen atom or a substitutent formed of a substituted or unsubstituted aryl group having 5 to 30 ring carbon atoms, a branched or straight-chain alkyl group having 1 to 30 carbon atoms or a substituted or unsubstituted cycloalkyl group having 3 to 20 carbon atoms, singly or in combination.

As the phenanthrene derivative, one represented by the following formula (5A) can be given.

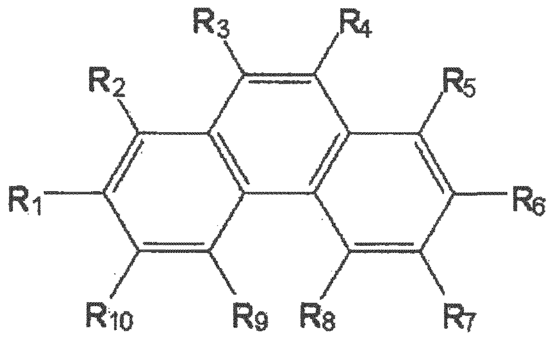

... (5A)

In the formula (5A), $R_1$ to $R_{10}$ are independently a hydrogen atom or a substituent formed of a substituted or unsubstituted aryl group having 5 to 30 ring carbon atoms, a branched or straight-chain alkyl group having 1 to 30 carbon atoms, a substituted or unsubstituted cycloalkyl group having 3 to 20 carbon atoms, singly or in combination.

As the chrysene derivative, one represented by the following formula (6A) can be given, for example.

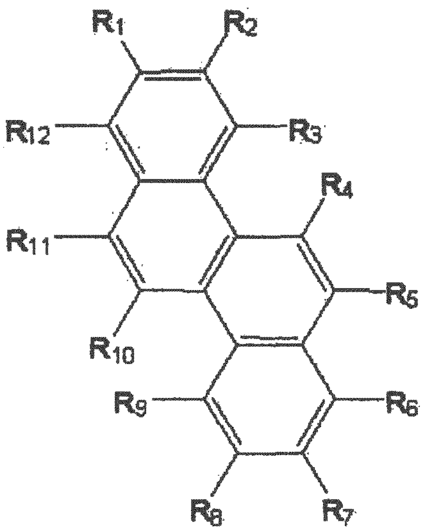

... (6A)

In the formula (6A), $R_1$ to $R_{12}$ are independently a hydrogen atom or a substituent formed of a substituent formed of a substituted or unsubstituted aryl group having 5 to 30 ring carbon atoms, a branched or straight-chain alkyl group having 1 to 30 ring carbon atoms and a substituted or unsubstituted cycloalkyl group having 3 to 20 carbon atoms,

singly or in combination.

Further, it is preferred that the polycyclic aromatic skeleton part be benzo[c]phenanthrene or its derivatives. As the benzo[c]phenanthrene derivative, one represented by the following formula (7A) can be given, for example.

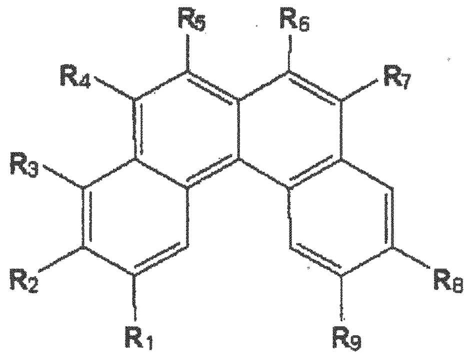

... (7A)

In the formula (7A), $R_1$ to $R_9$ are independently a hydrogen atom or a substituent formed of a substituted or unsubstituted aryl group having 5 to 30 ring carbon atoms, a branched or straight-chain alkyl group having 1 to 30 carbon atoms and a substituted or unsubstituted cycloalkyl group having 3 to 20 carbon atoms, singly or in combination.

Further, it is preferred that the above-mentioned polycyclic aromatic skeleton part be benzo[c]chrysene or its derivatives. As the benzo[c]chrysene derivative, a derivative represented by the following formula (8A) can be given, for example.

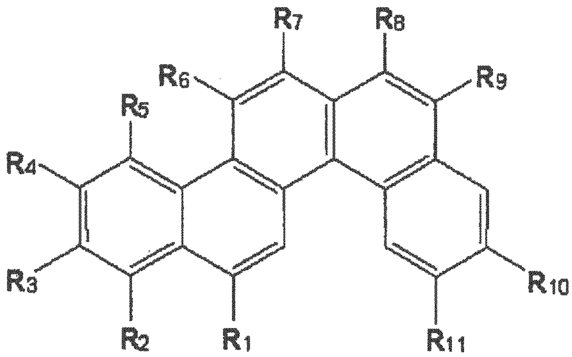

... (8A)

In the formula (8A), $R_1$ to $R_{11}$ are independently a hydrogen atom or a substituent formed of a substituted or unsubstituted aryl group having 5 to 30 ring carbon atoms, a branched or straight-chain alkyl group having 1 to 30 carbon atoms, a substituted or unsubstituted cycloalkyl group having 3 to 20 carbon atoms, singly or in combination.

It is preferred that the polycyclic aromatic skeleton part be dibenzo[c,g]phenanthrene or its derivatives represented by the following formula (9).

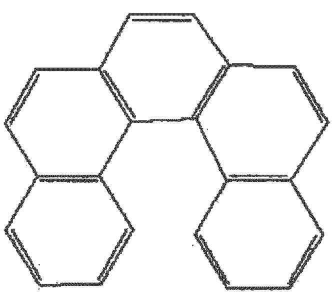

... (9)

It is preferred that the polycyclic aromatic skeleton part be fluoranthene or its derivatives. As the fluoranthene derivative, one represented by the following formula (10A) can be given, for example.

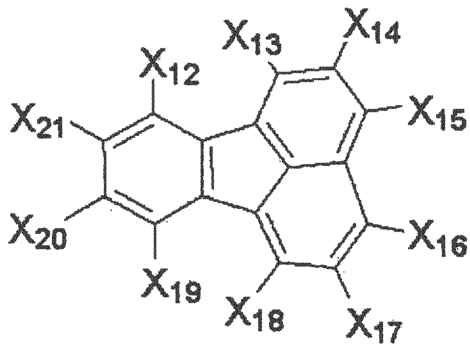

... (10A)

In the formula (10A), $X_{12}$ to $X_{21}$ are a hydrogen atom, a straight-chain, branched or cyclic alkyl group, a straight-chain, branched or cyclic alkoxy group, a substituted or unsubstituted aryl group or a substituted or unsubstituted heteroaryl group.

Further, it is preferred that the polycyclic aromatic skeleton part be triphenylene or its derivative. As the triphenylene derivative, one represented by the following formula (11A) can be given, for example.

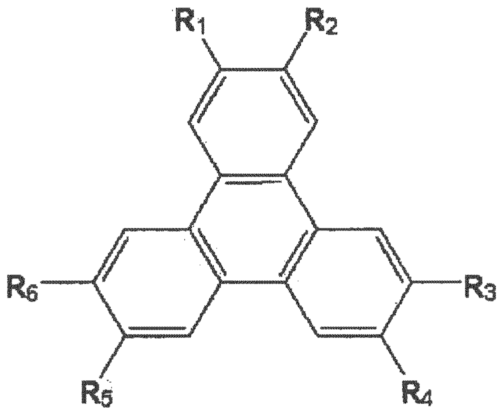

... (11A)

In the formula (11A), $R_1$ to $R_6$ are independently a hydrogen atom, or a substituent formed of a substituted or unsubstituted aryl group having 5 to 30 ring carbon atoms, a branched or straight-chain alkyl group having 1 to 30 carbon atoms and a substituted or unsubstituted cycloalkyl group having 3 to 20 carbon atoms, singly or in combination.

The polycyclic aromatic compound may be one represented by the following formula (12):

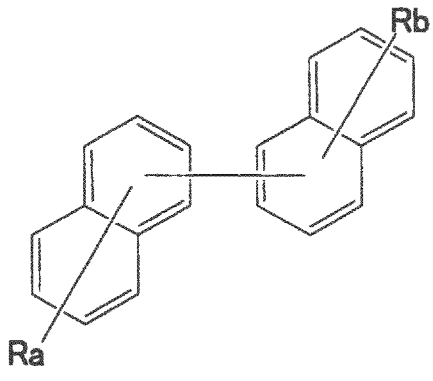

• • •(12)

In the formula (12), Ra and Rb are as defined in the formulas (A) to (C). If Ra, Rb and a naphthalene ring each has one or a plurality of substituent, the substituent is an alkyl group 1 to 20 carbon atoms, a haloalkyl group having 1 to 20 carbon atoms, a cycloalkyl group having 5 to 18 carbon atoms, a silyl group having 3 to 20 carbon atoms, a cyano group or a halogen atom, provided that the substituent of the naphthalene ring other than Ra and Rb may be an aryl group having 6 to 22 carbon atoms.

In the formula (12), it is preferred that Ra and Rb be a group selected from a fluorene ring, a phenanthrene ring, a triphenylene ring, a benzophenanthrene ring, a dibenzophenanthrene ring, a benzotriphenylene ring, a fluoranthene ring, a benzochrysene ring, a benzo[b]fluoranthene ring and a picene ring.

It is preferred that the material for the blocking layer be a material which shows a reversible oxidization process in the cyclic voltammetry measurement.

As for the mobility of the material for the blocking layer, it is preferred that the electric mobility (measured by the impedance spectrometry) be $10^{-6}$ $cm^2/Vs$ or more in the range of a field intensity of 0.04 to 0.5 MV/cm.

An explanation will be made on the measurement of the mobility by the impedance spectrometry. A material for a blocking layer having a thickness of about 100 nm to 200 nm is sandwiched by an anode and a cathode, and a minor alternating voltage of 100 mV or less is applied while applying a biased DC voltage. The value of alternating current (the absolute value and the phase) that flows at this time is measured. This measurement is conducted while changing the frequency of the alternating voltage. The complex impedance (Z) is calculated from the current value and the voltage value. At this time, the dependency of the imaginary part (ImM) of the modulus $M=i\omega Z$ (i: imaginary unit, w: angular frequency) on the frequency is obtained. The reciprocal of the frequency $\omega$ at which the ImM becomes maximum is defined as the response time of electrons that conduct the blocking layer. The electron mobility is calculated by the following formula:

$$\text{Electron mobility} = (\text{film thickness of a material of the blocking layer})^2/(\text{response time} \cdot \text{voltage})$$

As the specific examples of the material having an electric mobility of $10^{-6}$ $cm^2/Vs$ or more in the range of a field intensity of 0.04 to 0.5 MV/cm, a material having a fluoranthene derivative at a skeleton part of the polycyclic aromatic ring can be given.

(7) Space layer (charge-blocking layer)

As for the charge-blocking layer, statements are made in Patent No. 4134280, US2007/0273270A1 and WO2008/023623A1 or the like.

EXAMPLES

The invention will be explained in more detail with reference to the examples and the comparative examples which should not be construed as limiting the scope of the invention.

The chemical formulas of the materials used in Examples and Comparative Examples are given below.

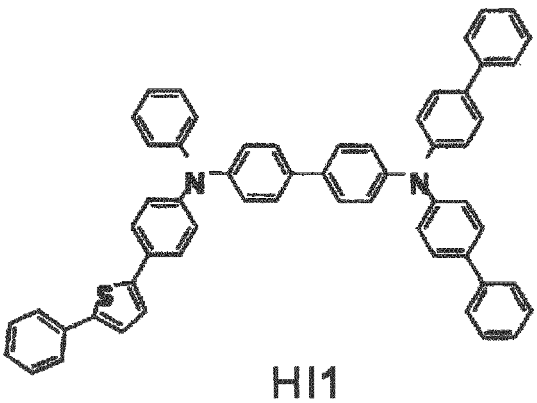

HI1

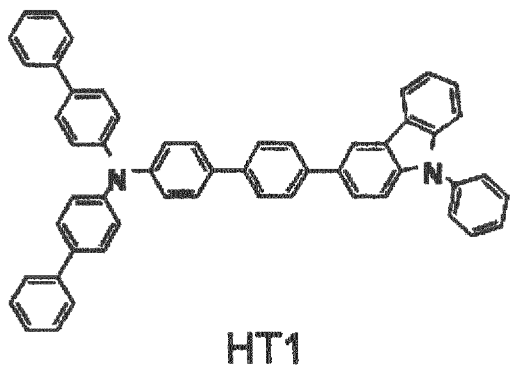

HT1

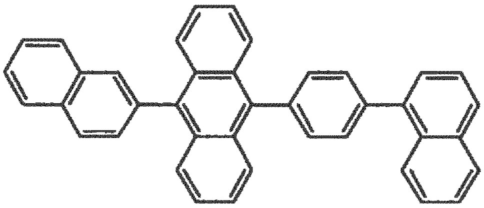

BH1

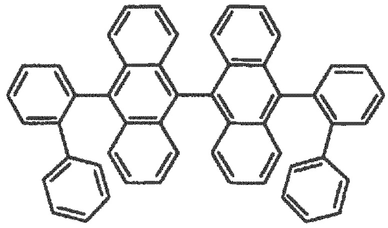

BH2

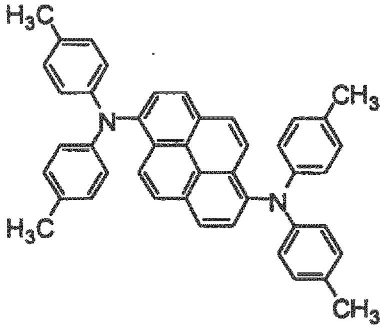

BD1

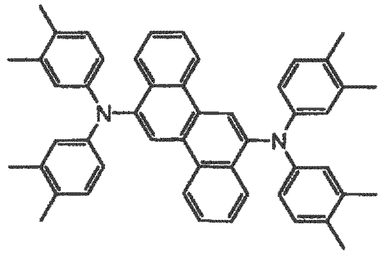

BD

BD2

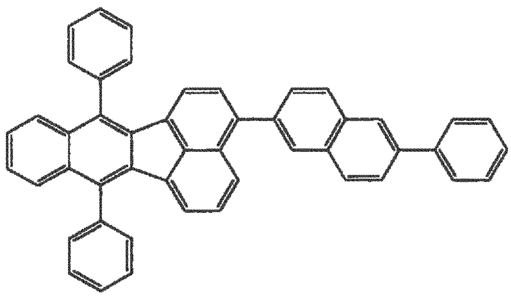

BD3

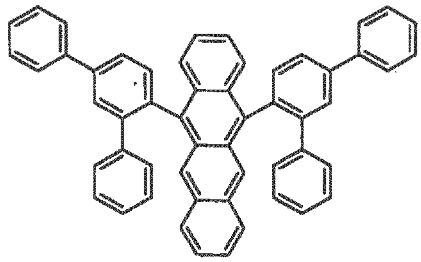

RH1

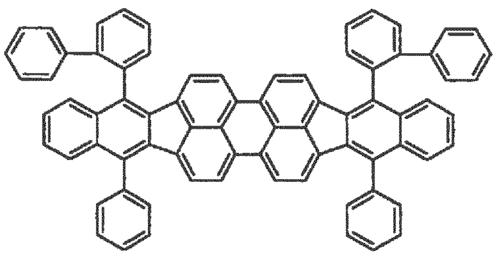

RD1

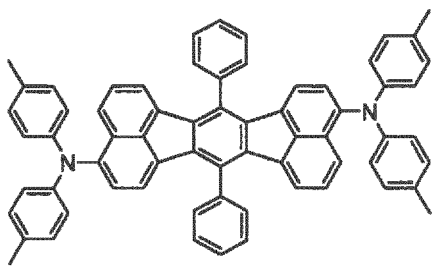

RD2

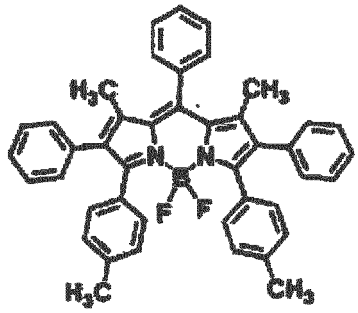

RD3

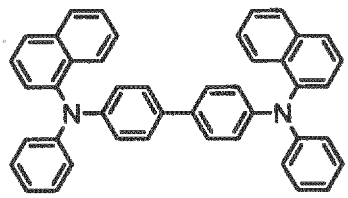

PRH1

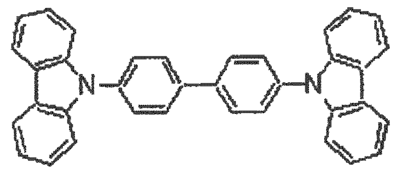

PGH1

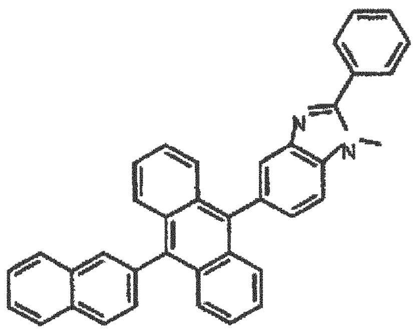

ET1

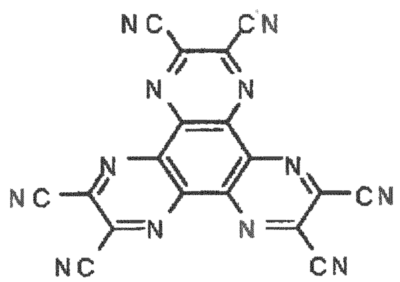

HAT

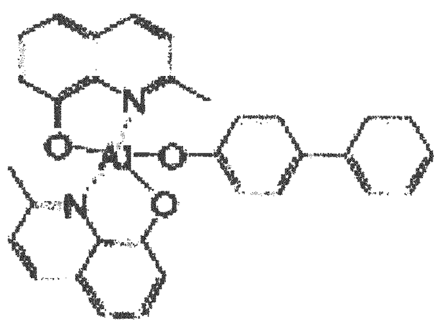

BAlq

Example 1

(1) Fabrication of an organic EL device

The organic EL device according to Example 1 was fabricated as follows.

A glass substrate (manufactured by Geomatics Co.), measuring 25 mm x 75 mm x 1.1 mm thick, with an ITO transparent electrode (anode) was subjected to ultrasonic cleaning in isopropyl alcohol for 5 minutes and then to UV ozone cleaning for 30 minutes.

On this glass substrate, a first emitting unit was formed.

The cleaned glass substrate with transparent electrode lines was mounted on a substrate holder in a vacuum deposition device. Compound HI1 was stacked on the surface where the transparent electrode lines were formed so as to cover the transparent electrode by resistance heating deposition. By this, a hole-injecting layer with a thickness of 50 nm which is in adjacent with the anode was formed.

On this hole-injection layer, compound HT1 was stacked by resistance heating deposition. As a result, a hole-transporting layer having a thickness of 45 nm was formed.

On this hole-transporting layer, compound BH1 as the host and compound BD1 as the fluorescent emitting dopant were co-deposited by resistance heating. As a result, 5 nm-thick emitting layer (blue fluorescent emitting layer) showing blue emission was formed. The concentration of compound BD1 was 5 mass%.

On this blue fluorescent emitting layer, compound BH1 as the host and compound RD1 as the fluorescent emitting dopant were co-deposited by resistance heating. As a result, a 25 nm-thick emitting layer (red fluorescent emitting layer) showing red emission was formed. The concentration of compound RD1 was 1 mass%.

On the red fluorescent emitting layer, Li as the electron donating material and compound ET1 as the electron-transporting material were co-deposited by resistance heating. The lithium dispenser manufactured by SAES Getters (LI/BD/GR/100 x 24 x 6/200) was used as a lithium deposition source. As a result, a 20 nm-thick electron-injecting layer was formed. The Li concentration was 5 mass%.

In this way, a first emitting unit formed of a hole-injecting layer which is in adjacent to the anode, a hole-transporting layer, a blue fluorescent emitting layer, a red fluorescent emitting layer and an electron-injecting layer was formed.

Next, an intermediate unit was formed on this first emitting unit.

When the intermediate unit was formed, a zinc oxide layer was stacked by resistance heating deposition. Further, compound HAT as the electron-accepting material was stacked by the resistance heating deposition, whereby a hole-injecting layer having a thickness of 10 nm was formed.

In this way, an intermediate unit formed of a zinc oxide layer was formed.

Next, a second emitting unit was formed on this intermediate unit.

When the second emitting unit was formed, first, on the intermediate unit, compound HAT as the electron-accepting material was stacked by the resistance heating deposition, whereby a hole-injecting layer having a thickness of 10 nm was formed.

On this hole-injecting layer, compound HI1 was stacked by the resistance heating deposition. As a result, a first hole-transporting layer having a thickness of 20 nm was formed.

On this first hole-transporting layer, compound HT1 was stacked by resistance heating deposition. As a result, a second hole-transporting layer having a thickness of 10 nm was formed.

On this second hole-transporting layer, compound PRH1 as the host and compound $Ir(tpiq)_2(acac)$(PRD1) as the phosphorescent emitting dopant were co-deposited by the resistance heating deposition. As a result, a red emitting layer (red phosphorescent emitting layer) having a thickness of 10 nm showing red emission was formed. The concentration or compound of $Ir(tpiq)_2(acac)$ was 2 mass%.

On this red phosphorescent emitting layer, compound PGH1 as the host and compound $Ir(ppy)_3$(PGD1) as the phosphorescent emitting dopant were co-deposited by the resistance heating. As a result, an emitting layer (green phosphorescent emitting layer) having a thickness of 30 nm showing green emission was formed. The concentration of the compound $Ir(ppy)_3$ was 10 mass%. On this green phosphorescent emitting layer, compound BAlq was stacked by the resistance heating deposition. As a result, a hole-blocking layer having a thickness of 10 nm was formed.

Then, on this emitting layer, Li as the electron-donating material and compound ET1 as the electron-transporting material were co-deposited by resistance heating. As a result, an electron-injecting layer (thickness: 25 nm) which is adjacent to the cathode. The Li concentration was 5 mass%.

In this way, a second emitting unit formed of a first hole-transporting layer, a second hole-transporting layer, a red phosphorescent emitting layer, a green phosphorescent emitting layer and an electron-injecting layer which is adjacent to the cathode was formed.

Then, on the electron-injecting layer which is adjacent to the second emitting unit, metal aluminum (Al) was deposited to form a cathode having a thickness of 100 nm.

(2) Evaluation of an organic EL device

The organic EL device fabricated above was driven, and a voltage was applied such that the current density became 10 $mA/cm^2$.

The EL emission spectrum at the time of driving was measured by means of a spectroradiometer (CS-1000, Konica

Minolta, Optics, Inc.). From the resulting spectral radiance, the power efficiency η and the color temperature were calculated. Further, the half life (unit: khrs) was measured by conducting a continuous-current test at an initial luminance of 1,000 cd/$m^2$. The results are shown in Table 1.

Examples 2 to 26 and Comparative Examples 1 to 6

Organic EL devices were fabricated in the same manner as in Example 1, except that the configurations of the emitting layer of the first emitting unit and the second emitting unit were changed to those in the emitting layers shown in Tables 1 to 4.
The numerals in the parenthesis () in the tables indicate the thickness of each layer (unit: nm) or the concentration of the dopant (unit: %).
Table 1

| | First emitting unit | Second emitting unit | Color temperature (K) | Power efficiency (lm/W) | Life (khrs) |
|---|---|---|---|---|---|
| Example 1 | BH1:BD1/BH1: RD1 (5:5%/25:1%) | PRH1: PRD1/PGH1: PGD1 (10:2%/30: 10%) | 2700 | 28.0 | 36 |
| Example 2 | BH2:BD1/BH2: RD1 (5:5%/25:1%) | PRH1: PRD1/PGH1: PGD1 (10:2%/30: 10%) | 2700 | 27.5 | 36 |
| Example 3 | BH1:BD2/BH1: RD1 (5:5%/25:1%) | PRH1: PRD1/PGH1: PGD1 (10:2%/30: 10%) | 2800 | 25.9 | 37 |
| Example 4 | BH2:BD2/BH2: RD1 (5:5%/25:1%) | PRH1: PRD1/PGH1: PGD1 (10:2%/30: 10%) | 2800 | 25.8 | 40 |
| Example 5 | BH1:BD3/BH1: RD1 (5:5%/25:1%) | PRH1: PRD1/PGH1: PGD1 (10:2%/30: 10%) | 2700 | 27.1 | 50 |
| Example 6 | BH2:BD3/BH2: RD1 (5:5%/25:1%) | PRH1: PRD1/PGH1: PGD1 (10:2%/30: 10%) | 2700 | 27.4 | 49 |
| Example 7 | BH1:BD3/BH1: RD3 (5:5%/25:1%) | PRH1: PRD1/PGH1: PGD1 (10:2%/30: 10%) | 2700 | 28.4 | 46 |
| Example 8 | BH2:BD3/BH2: RD3 (5:5%/25:1%) | PRH1: PKD1/PGH1: PGD1 (10:2%/30: 10%) | 2700 | 27.9 | 49 |

Table 2

| | First emitting unit | Second emitting unit | Color temperature (K) | Power efficiency (lm/W) | Lifetime (khrs) |
|---|---|---|---|---|---|
| Example 9 | RH1: RD1/HT1/BH1: BD1 (5:1%/3/22: 5%) | PRH1: PRD1/PGH1: PGD1 (10:2%/ 30:10%) | 2700 | 29.2 | 35 |
| Example 10 | RH1: RD1/HT1/BH2: BD1 (5:1%/3/22: 5%) | PRH1: PRD1/PGH1: PGD1 (10:2%/ 30:10%) | 2700 | 28.6 | 38 |
| Example 11 | RH1: RD1/HT1/BH1: BD2 (5:1%/3/22: 5%) | PRH1: PRD1/PGH1: PGD1 (10:2%/ 30:10%) | 2800 | 26.8 | 35 |
| Example 12 | RH1: RD1/HT1/BH2: BD2 (5:1%/3/22: 5%) | PRH1: PRD1/PGH1: PGD1 (10:2%/ 30:10%) | 2800 | 26.3 | 42 |
| Example 13 | RH1: RD1/HT1/BH1: BD3 (5:1%/3/22: 5%) | PRH1: PRD1/PGH1: PGD1 (10:2%/ 30:10%) | 2700 | 28.5 | 51 |
| Example 14 | RH1: RD1/HT1/BH2: BD3 (5:1%/3/22: 5%) | PRH1: PRD1/PGH1: PGD1 (10:2%/ 30:10%) | 2700 | 28.4 | 55 |
| Example 15 | RH1: RD2/HT1/BH1: BD3 (5:5%/3/22: 5%) | PRH1: PRD1/PGH1: PGD1 (10:2%/ 30:10%) | 2700 | 25.7 | 45 |
| Example 16 | RH1: RD3/HT1/BH1: BD3 (5:1%/3/22: 5%) | PRH1: PRD1/PGH1: PGD1 (10:2%/ 30:10%) | 2700 | 29.6 | 53 |
| Example 17 | RH1: RD3/HT1/BH2: BD3 (5:1%/3/22: 5%) | PRH1: PRD1/PGH1: PGD1 (10:2%/ 30:10%) | 2700 | 28.6 | 55 |

Table 3

| | First emitting unit | Second emitting unit | Color temperature (K) | Power efficiency (lm/W) | Lifetime (khrs) |
|---|---|---|---|---|---|
| Example 18 | RH1:RD1/BH1: BD1 (2:1%/28: 5%) | PRH1: PRD1/PGH1: PGD1 (10:2%/ 30:10%) | 2700 | 30.7 | 42 |

(continued)

| | First emitting unit | Second emitting unit | Color temperature (K) | Power efficiency (lm/W) | Lifetime (khrs) |
|---|---|---|---|---|---|
| Example 19 | RH1: RD1/HT1/BH2: BD1 (2:1%/3/28: 5%) | PRH1: PRD1/PGH1: PGD1 (10:2%/ 30:10%) | 2700 | 29.8 | 52 |
| Example 20 | RH1: RD1/HT1/BH1: BD2 (2:1%/3/28: 5%) | PRH1: PRD1/PGH1: PGD1 (10:2%/ 30:10%) | 2800 | 28.1 | 41 |
| Example 21 | RH1: RD1/HT1/BH2: BD2 (2:1%/3/28: 5%) | PRH1: PRD1/PGH1: PGD1 (10:2%/ 30:10%) | 2800 | 27.7 | 48 |
| Example 22 | RH1: RD1/HT1/BH1: BD3 (2:1%/3/28: 5%) | PRH1: PRD1/PGH1: PGD1 (10:2%/ 30:10%) | 2700 | 29.0 | 54 |
| Example 23 | RH1: RD1/HT1/BH2: BD3 (2:1%/3/28: 5%) | PRH1: PRD1/PGH1: PGD1 (10:2%/ 30:10%) | 2700 | 29.1 | 55 |
| Example 24 | RH1: RD2/HT1/BH1: BD3 (2:5%/3/28: 5%) | PRH1: PRD1/PGH1: PGD1 (10:2%/ 30:10%) | 2700 | 26.9 | 43 |
| Example 25 | RH1: RD3/HT1/BH1: BD3 (2:1%/3/28: 5%) | PRH1: PRD1/PGH1: PGD1 (10:2%/ 30:10%) | 2700 | 31.0 | 58 |
| Example 26 | RH1: RD3/HT1/BH2: BD3 (2:1%/3/28: 5%) | PRH1: PRD1/PGH1: PGD1 (10:2%/ 30:10%) | 2700 | 30.5 | 55 |

Table 4

| | First emitting unit | Second emitting unit | Color temperature (K) | Power efficiency (lm/W) | Life (khrs) |
|---|---|---|---|---|---|
| Com. Ex. 1 | BH1:BD1 (30:5%) | PRH1: PRD1/PGH1:PGD1 (10:2%/30:10%) | 3000 | 25.5 | 24 |
| Com. Ex. 2 | BH2:BD1 (30:5%) | PRH1: PRD1/PGH1:PGD1 (10:2%/30:10%) | 3000 | 24.9 | 29 |
| Com. Ex. 3 | BH1:BD2 (30:5%) | PRH1: PRD1/PGH1:PGD1 (10:2%/30:10%) | 3200 | 23.6 | 26 |

(continued)

| | First emitting unit | Second emitting unit | Color temperature (K) | Power efficiency (lm/W) | Life (khrs) |
|---|---|---|---|---|---|
| Com. Ex. 4 | BH2:BD2 (30:5%) | PRH1: PRD1/PGH1:PGD1 (10:2%/30:10%) | 3200 | 23.3 | 29 |
| Com. Ex. 5 | BH1:BD3 (30:5%) | PRH1: PRD1/PGH1:PGD1 (10:2%/30:10%) | 3000 | 24.8 | 40 |
| Com. Ex. 6 | BH2:BD3 (30:5%) | PRH1: PRD1/PGH1:PGD1 (10:2%/30:10%) | 3000 | 24.7 | 45 |

As shown in Tables 1 to 4, although the color temperature is low in Examples and Comparative Examples, efficiency was high in Examples as compared with Comparative Examples. In Comparative Examples, blue emission was suppressed, and hence, efficiency was low due to the presence of discarded energy. On the other hand, in Examples, the discarded energy was allowed to emit as red fluorescence. Further, by addition of new red components, the emission temperature was shifted to the low direction. In order to allow the discarded energy to emit as red fluorescence, and further, in order to allow the suppressed blue emission to emit, efficiency was increased in Examples. Due to such an increase in efficiency, the current density required is lowered when the lifetime is measured at the constant luminance, whereby the device can have a long life.

INDUSTRIAL APPLICABILITY

The organic EL device according to the invention is suited to be used in illumination having a low color temperature (2500K to 4000K, for example).

Although only some exemplary embodiments and/or examples of this invention have been described in detail above, those skilled in the art will readily appreciate that many modifications are possible in the exemplary embodiments and/or examples without materially departing from the novel teachings and advantages of this invention. Accordingly, all such modifications are intended to be included within the scope of this invention.

The documents described in the specification are incorporated herein by reference in its entirety.

## Claims

**1.** A tandem organic electroluminescence device comprising a first emitting unit, an intermediate unit and a second emitting unit being stacked between opposing electrodes,
the first emitting unit comprising a fluorescent dopant having an emission wavelength of 400 to 490 nm and a fluorescent dopant having an emission wavelength of 560 to 700 nm; and
the second emitting unit comprising a phosphorescent dopant having an emission wavelength of 560 to 700 nm and a phosphorescent dopant having an emission wavelength of 490 to 560 nm.

**2.** The organic electroluminescence device according to claim 1, wherein the first emitting unit comprises a blue fluorescent dopant and a yellow fluorescent dopant and the second emitting unit comprises a red phosphorescent dopant and a green phosphorescent dopant.

**3.** The organic electroluminescence device according to claim 1, wherein
the first emitting unit comprises a first emitting layer and a second emitting layer;
the first emitting layer comprises the yellow fluorescent dopant;
the second emitting layer comprises the blue fluorescent dopant;
the second emitting unit comprises a third emitting layer and a fourth emitting layer;
the third emitting layer comprises the red phosphorescent dopant; and
the fourth emitting layer comprises the green phosphorescent dopant.

**4.** A tandem organic electroluminescence device comprising a first emitting unit, an intermediate unit and a second

emitting unit being stacked between opposing electrodes,
the first emitting unit comprising a blue fluorescent dopant and a red fluorescent dopant; and the second emitting unit comprising a red phosphorescent dopant and a green phosphorescent dopant.

**5.** The organic electroluminescence device according to claim 4, wherein
the first emitting unit comprises a first emitting layer and a second emitting layer;
the first emitting layer comprises the red fluorescent dopant;
the second emitting layer comprises the blue fluorescent dopant;
the second emitting unit comprises a third emitting layer and a fourth emitting layer;
the third emitting layer comprises the red phosphorescent dopant; and
the fourth emitting layer comprises the green phosphorescent dopant.

**6.** The organic electroluminescence device according to claim 5, wherein the first emitting unit comprises a blocking layer which is adjacent to the second emitting layer.

**7.** The organic electroluminescence device according to claim 5 or 6, wherein the second emitting layer comprises a host compound and the triplet energy of the host compound is smaller than the triplet energy of the compound forming the blocking layer.

**8.** The organic electroluminescence device according to claim 7, wherein the triplet energy of the blue fluorescent dopant is smaller than the triplet energy of the compound forming the blocking layer.

**9.** The organic electroluminescence device according to any of claims 5 to 8, wherein the first emitting unit comprises a space layer between the first emitting layer and the second emitting layer.

FIG.1

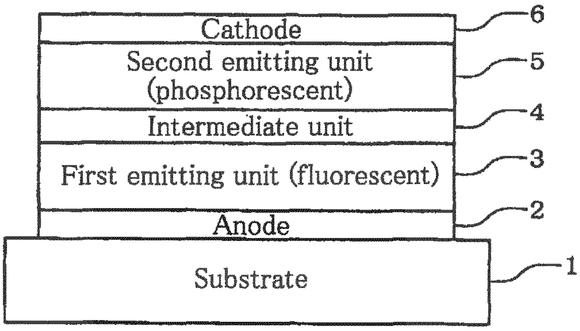


FIG.2

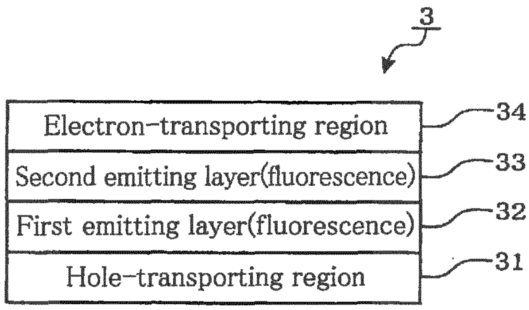


FIG.3

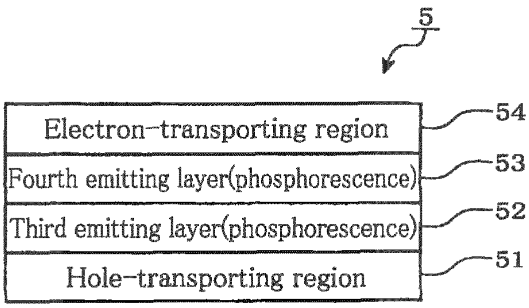


FIG.4

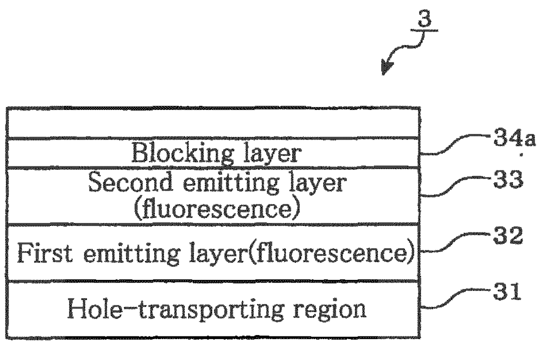

FIG.5A

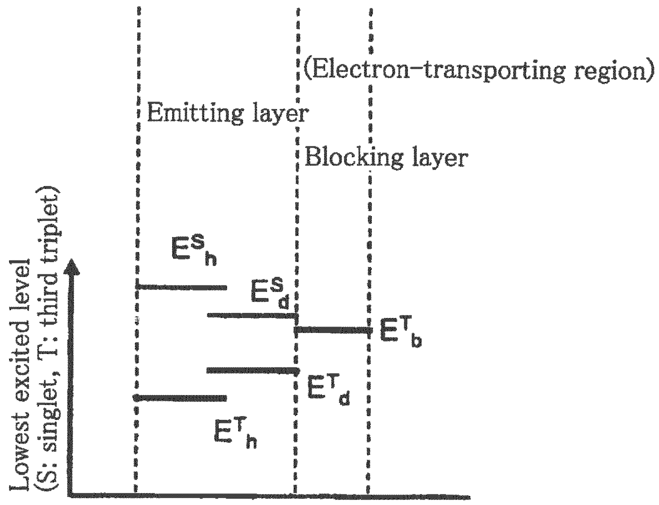


FIG.5B

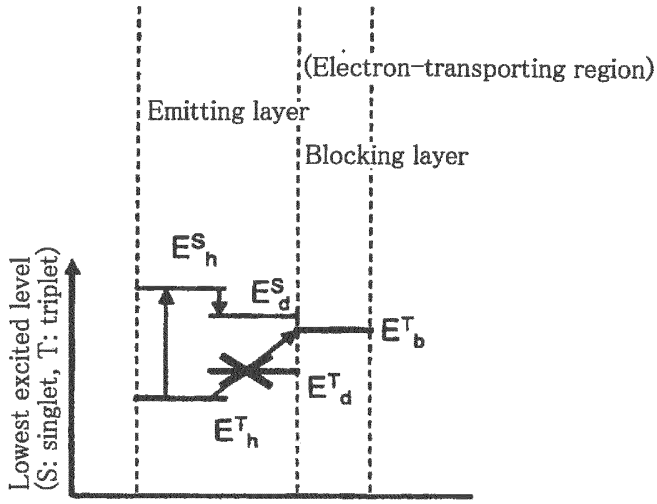


FIG.6

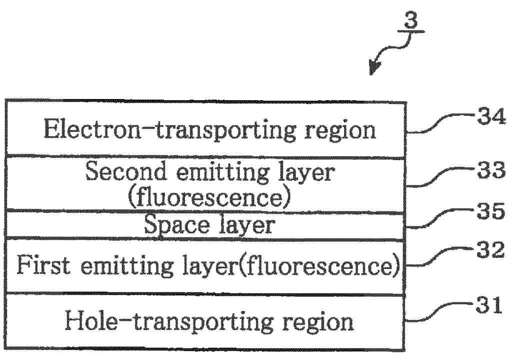

FIG.7

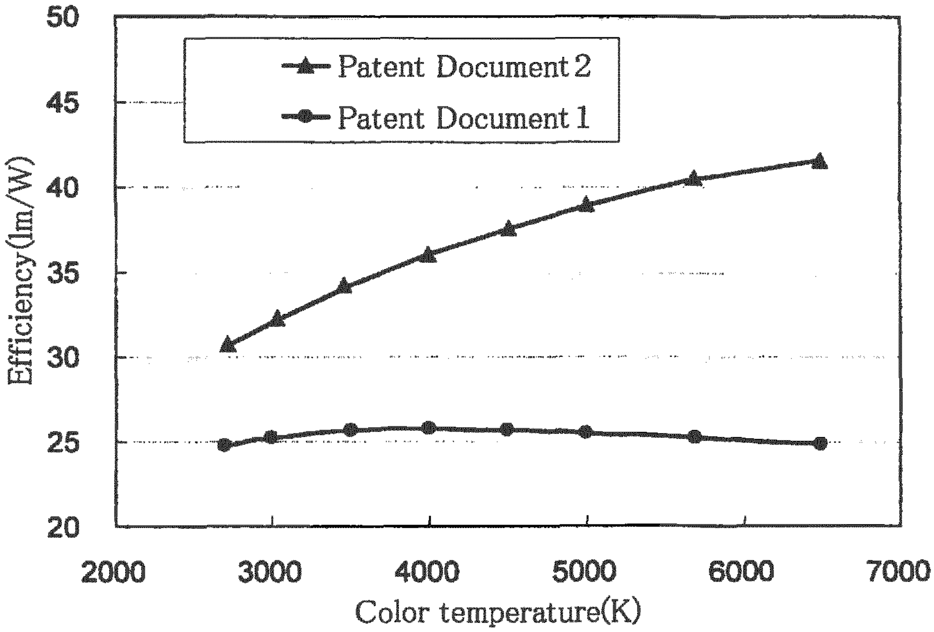
Patent Document 2
Patent Document 1
50
45
40
35
30
25
20
Efficiency(lm/W)
2000
3000
4000
5000
6000
7000
Color temperature(K)

**INTERNATIONAL SEARCH REPORT**

International application No.
PCT/JP2011/005879

A. CLASSIFICATION OF SUBJECT MATTER
*H05B33/12*(2006.01)i, *H01L51/50*(2006.01)i

According to International Patent Classification (IPC) or to both national classification and IPC

B. FIELDS SEARCHED

Minimum documentation searched (classification system followed by classification symbols)
H05B33/12, H01L51/50

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2006/013738 A1 (Konica Minolta Holdings, Inc.), 09 February 2006 (09.02.2006), entire text; all drawings & JP 2011-109113 A & US 2008/0303415 A1 & EP 1786242 A1 | 1-9 |
| A | WO 2008/123178 A1 (Idemitsu Kosan Co., Ltd.), 16 October 2008 (16.10.2008), entire text; all drawings & US 2010/0044689 A1 & EP 2133932 A1 | 1-9 |
| A | JP 2007-59310 A (Konica Minolta Holdings, Inc.), 08 March 2007 (08.03.2007), paragraph [0095] (Family: none) | 1-9 |

☒ Further documents are listed in the continuation of Box C.

☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
07 November, 2011 (07.11.11)

Date of mailing of the international search report
15 November, 2011 (15.11.11)

Name and mailing address of the ISA/
Japanese Patent Office

Facsimile No.

Authorized officer

Telephone No.

Form PCT/ISA/210 (second sheet) (July 2009)

**INTERNATIONAL SEARCH REPORT**

International application No.
PCT/JP2011/005879

C (Continuation). DOCUMENTS CONSIDERED TO BE RELEVANT

| Category* | Citation of document, with indication, where appropriate, of the relevant passages | Relevant to claim No. |
|---|---|---|
| A | JP 2007-250296 A (Konica Minolta Holdings, Inc.), 27 September 2007 (27.09.2007), entire text; all drawings (Family: none) | 1-9 |
| A | JP 2002-260859 A (Matsushita Electric Industrial Co., Ltd.), 13 September 2002 (13.09.2002), paragraph [0023] (Family: none) | 1-9 |
| A | JP 2009-93981 A (Seiko Epson Corp.), 30 April 2009 (30.04.2009), entire text; all drawings (Family: none) | 1-9 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2007138906 A
- WO 2007005200 A
- JP 2005267990 A
- US 7252893 B, Rick
- US 6818327 B
- WO 2009011327 A
- WO 2009069717 A
- WO 2010064655 A
- JP 2010003434 W
- JP 2005072012 A
- JP H11345687 A
- JP 2009090379 A
- WO 4134280 A
- US 20070273270 A1
- WO 2008023623 A1